# EUROPÄISCHE PATENTSCHRIFT

(11) **EP 4 166 966 B1**
(45) Veröffentlichungstag und Bekanntmachung des Hinweises auf die Patenterteilung: **10.04.2024**
(21) Anmeldenummer: 22200894.8
(22) Anmeldetag: 11.10.2022
(51) Int. Cl.: G01R 31/58, G01R 31/54, G01R 31/60

(54) **TEST VON KABELBÄUMEN MIT MECHANISCH EMPFINDLICHEN KONTAKTENDEN**
TESTING OF WIRING HARNESSES WITH MECHANICALLY SENSITIVE CONTACT ENDS
ESSAI DE FAISCEAUX DE CÂBLES AVEC DES EXTRÉMITÉS DE CONTACT SENSIBLES MÉCANIQUEMENT

(30) Priorität: 14.10.2021 DE 102021126666
(43) Veröffentlichungstag der Anmeldung: 19.04.2023
(73) Patentinhaber: ESPI Logistics GmbH, 91126 Schwabach (DE)
(72) Erfinder: Lochmann, Rüdiger, 91126 Schwabach (DE)
(74) Vertreter: Kanzlei Dr. Negendanck Patentmanufaktur

(56) Entgegenhaltungen:
- DE-B4-102011 087 152
- US-A1- 2012 126 823
- US-A1- 2021 247 463
- US-B1- 7 112 969

## Beschreibung

Die Erfindung betrifft ein Testsystem zur Überprüfung einzelner Adern eines Kabelbaums, zumindest auf elektrische Durchgängigkeit.

Als Kabelbaum wird die Zusammenfassung verschiedenartiger elektrischer Adern oder Leitungen zu einem - auch verzweigten - Strang bezeichnet. Die einzelnen Adern weisen dabei stets zwei Kontaktenden auf und können dabei einfache Durchgangsleitungen zwischen tatsächlich nur zwei Kontaktenden sein. Adern können jedoch auch Teile von Leitungen mit drei oder mehr Kontaktenden sein, z.B. weist eine Y-Leitung mit drei Kontaktenden damit zwei Adern mit je zwei Kontaktenden auf, wobei zwei der Kontaktenden zusammenfallen können (Verbinder / Doppelanschlag). An den Kontaktenden sind üblicherweise Steckverbinder (Kontaktelemente in einem Steckverbindergehäuse) angebracht.

Bei seiner späteren Verwendung stellt der Kabelbaum die elektrischen Verbindungen - z.B. auch über Abzweigungen - zwischen verschiedenen elektrischen Komponenten, z.B. in Fahrzeugen oder Maschinen, her. In der Regel werden Kabelbäume nach der Fertigung auf Vollständigkeit (korrekte Verbindungen wie geplant, elektrischer "Durchgang" der einzelnen Adern) und Kurzschluss (z.B. fehlerhafte Verbindung zwischen zwei Adern oder nach Masse, usw.) getestet. Jede zu testende Ader weist dabei zwei Kontaktenden auf, zwischen denen der jeweilige elektrische Durchgangstest erfolgt, in der Regel über die angeschlossenen Steckverbinder. Ein Kurzschlusstest findet dagegen zwischen Kontaktenden (Steckverbinder) unterschiedlicher Adern bzw. Kontaktenden von Adern und Gegenstellen wie Masse oder dergleichen statt.

Für den Test eines Kabelbaums werden Kabelbaum-Testsysteme eingesetzt. Diese umfassen einen sogenannten Kabelbaumtester, kurz "Tester". Ein solcher ist z.B. als Produkt "CT 35" der Fa. TSK bekannt (siehe z.B. "Kabeltester CT35", Produktblatt (PDF, online), TSK Prüfsysteme GmbH, Porta Westfalica, http:// www.t-s-k.de/ fileadmin/ user_upload/ Flyer_2013/ Kabeltester/ K_Flyer_CT35_de.pdf, Abruf am 01.04.2021). Der Tester weist - einfach gesprochen - zwei Schnittstellen auf, zwischen welchen die zu testenden Adern elektrisch angeschlossen werden. Eine Schnittstelle wird über eine Strom- oder Spannungsquelle versorgt, die andere führt zu einer Stromsenke. Der eigentliche Kontakt zwischen je einer Schnittstelle und je einem Kontaktende der Ader wird über sogenannte, zwischen der Schnittstelle und dem Kabelbaum angeschlossene Prüfadapter bzw. Prüfmodule hergestellt (siehe z.B. "Prüfmodule", Produktinformationen (Internetseite), TSK Prüfsysteme GmbH, Porta Westfalica, https:// www.t-s-k.de/ de/ kabelpruefsysteme/ adaptionssysteme/ pruefmodule/, Abruf am 01.04.2021). Diese sorgen z.B. auch für eine hier nicht näher erläuterte elektrische Umschaltung zwischen einzelnen Adern eines mit mehreren Adern am Prüfmodul angeschlossenen Kabelbaums für den jeweiligen individuellen Test einer der Adern. Außerdem stellen sie den eigentlichen elektrischen und mechanischen Kontakt der Schnittstelle mit den Kontaktenden der Adern her. Übliche Prüfmodule benötigen an beiden Seiten der Adern des Kabelbaums Steckverbinder, um den Kabelbaum bzw. dessen Kontaktenden an die Prüfmodule bzw. deren Gegen-Steckverbinder elektrisch kontaktierend anzuschließen.

US7112969B1 beschreibt ebenfalls einen Kabelbaumtester.

Es gibt jedoch auch Kabelbäume, die vorgefertigt werden und bei denen Kontaktenden zunächst nur teilweise oder gar nicht mit Steckern bestückt sind. Dabei können entweder Kontaktenden selbst als offene Litzenenden vorliegen oder es sind bereits Kontaktelemente von Steckverbindern an den Kontaktenden angebracht, diese Kontaktelemente jedoch noch nicht in einem Steckverbindergehäuse aufgenommen. Derartige ("offene") Kontaktenden sind insbesondere mechanisch empfindlich und müssen dann aufwändig einzeln bzw. händisch, z.B. über Prüfmodule mit Kontaktklammern, mit den Schnittstellen verbunden werden.

Der Erfindung liegt die Aufgabe zugrunde, die Überprüfung eines Kabelbaumes - insbesondere wenn dieser wenigstens ein mechanisch empfindliches Kontaktende aufweist - mit einem Testsystem zu verbessern.

Die Aufgabe wird gelöst durch ein Ersatzprüfmodul gemäß Anspruch 1 für ein Testsystem bzw. für ein Prüfmodul eines solchen Testsystems. Bevorzugte oder vorteilhafte Ausführungsformen der Erfindung sowie anderer Erfindungskategorien ergeben sich aus den weiteren Ansprüchen, der nachfolgenden Beschreibung sowie den beigefügten Figuren. Vorliegend wird von folgenden Eigenschaften von angesprochenen Testsystemen ausgegangen bzw. ist das Ersatzprüfmodul bestimmungsgemäß für folgende Testsysteme einzusetzen: Das Testsystem weist - wie oben erläutert - mindestens zwei Schnittstellen zum Anschluss eines jeweiligen Prüfmoduls an einer der Schnittstellen auf. Nunmehr ist allerdings unter einem solchen "Prüfmodul" in Ergänzung zu oben auch das hier vorgeschlagene Ersatzprüfmodul zu verstehen, denn auch dieses ist an die Schnittstellen anschließbar. Das Testsystem kann genau zwei oder auch mehrere Schnittstellen aufweisen. Für die vorliegende Erfindung werden jedoch der Einfachheit halber nur zwei Schnittstellen betrachtet, zwischen denen eine aktuell zu testende Ader angeschlossen ist. Die Prüfmodule weisen dabei entsprechende Gegenschnittstellen zur Verbindung mit den Schnittstellen auf. Das Testsystem ist dazu eingerichtet, einen - vermittels der Prüfmodule - zwischen den Schnittstellen angeschlossenen Kabelbaum zumindest auf elektrischen Durchgang bzw. Durchgängigkeit (insbesondere Meldungen "Leitung erkannt" oder "Leitung fehlt" des Testsystems), gegebenenfalls auch Kurzschluss oder sonstige elektrische Korrektheit seiner Adern zu testen. "Durchgang / Durchgängigkeit / Leitung erkannt" ist hier ein ohmscher Widerstand von "Null", unter Berücksichtigung von Messfehlern etc. ggf. auch ein ohmscher Widerstand unterhalb eines Minimalwertes von z.B. 0,1 Ohm, 1 Ohm, 2 Ohm oder dergleichen. Ein Messstrom kann durch eine solche Ader praktisch ungehindert fließen. "Kein Durchgang / Leitung fehlt" ist gleichzusetzen mit einer Leitung, die einen ohmschen Widerstand über einem Grenzwert aufweist und daher z.B. ein kaum nennenswerter / nicht ausreichend hoher Messstrom durch die Ader fließt. Hierzu sind bzw. werden, wie oben erläutert, die Adern mit ihren Kontaktenden (gegebenenfalls unter Nutzung bzw. Zwischenschaltung der angebrachten Kontaktelemente / Steckverbinder) elektrisch zwischen die Schnittstellen geschaltet. Der Kabelbaum kann hierbei auch eine einzige Ader aufweisen; in der Regel wird dieser jedoch eine Vielzahl, d.h. etliche zehn oder etliche hundert Adern aufweisen. Der Kabelbaum wird dabei in der Regel vollständig zwischen den Schnittstellen kontaktiert und über eine nicht näher erläuterte Umschaltung werden sukzessive alle Adern getestet.

Die Prüfung auf "elektrische Korrektheit" ermittelt dabei insbesondere elektrische Eigenschaften der Adern bzw. des Kabelbaumes, wie z.B. ohmschen Widerstand der Adern, Kapazität zwischen Adern, usw. Vorliegend interessiert insbesondere die elektrische Durchgängigkeit einer Ader bzw. ein fehlerhafter Kurzschluss von einer Ader zu einem anderen Objekt, z.B. einer anderen Ader, Masse, usw. Der Kurzschluss wird dabei als Durchgängigkeit von einem Kontaktende einer Ader zu einem anderen unerwünschten Kontaktende / einer anderen Gegenstelle (Masse, Versorgungsspannung, ...) ermittelt. Insofern wird vorliegend insbesondere die elektrische Durchgängigkeit einer jeweiligen Ader bzw. zwischen zwei jeweiligen Kontaktenden untersucht.

Das Testsystem, ggf. mit ein oder zwei Prüfmodulen (also ohne Ersatzprüfmodul) wird im Folgenden auch als "Fremdprüfsystem" bezeichnet. Dies bezieht sich darauf, dass aus Sicht des Herstellers bzw. Entwicklers (z.B. Unternehmen "N") des Ersatzprüfmoduls das Testsystem / die Prüfmodule von einem anderen Hersteller (z.B. Unternehmen "H") stammen. Insofern sind dem Hersteller / Entwickler N die technischen Daten und Eigenschaften, die Abläufe im Inneren des Testsystems usw. für die Entwicklung des Ersatzprüfmoduls an sich nicht bekannt. Entsprechende Eigenschaften sind daher vom Hersteller N anzunehmen oder - zum Beispiel anhand einer unten erläuterten Kalibrierung - möglichst zu ermitteln. Insofern ist auch das "Prüfmodul" des Herstellers H als "Fremdprüfmodul" zu verstehen, das bestimmungsgemäß für den Einsatz am Fremdprüfsystem bestimmt ist, insbesondere von dessen Hersteller H stammt oder zumindest in Kenntnis des Fremdprüfsystems basierend auf von H gelieferten Informationen entwickelt wurde.

Insofern ist der Begriff "Ersatzprüfmodul" des Herstellers N dahingehend zu verstehen, dass dieses Prüfmodul als "Ersatz" für "Original"-Prüfmodule (Hersteller H, bzw. basierend auf dessen Informationen) des Fremdprüfsystem zu verstehen ist.

Das Ersatzprüfmodul enthält eine Gegenschnittstelle zum Anschluss an eine der Schnittstellen des Testsystems. Insbesondere ist die Gegenschnittstelle wahlweise an eine beliebige von beiden Schnittstellen des Testsystems anschließbar. Das Ersatzprüfmodul ist damit anstelle eines ansonsten für den Tester verfügbaren Prüfmoduls an der Schnittstelle und damit am Tester anschließbar. Das Ersatzprüfmodul wird durch den Anschluss an der Schnittstelle somit Teil des (modifizierten) Testsystems.

Das Ersatzprüfmodul enthält mindestens einen Kontakt zur elektrischen Kontaktierung eines jeweiligen Kontaktendes einer Ader des Kabelbaums. Insbesondere sind mehrere Kontakte vorgesehen, um ein jeweiliges Kontaktende des Kabelbaums zu kontaktieren. Dabei wird insbesondere wie bei herkömmlichen Prüfmodulen vorgegangen, d.h. hinsichtlich der notwendigen Anzahl von Kontakten ein Ersatzprüfmodul speziell für einen zu prüfenden Kabelbaum entworfen oder ein Ersatzprüfmodul mit einer ausreichenden Anzahl von Kontakten verwendet. Eine ggf. erforderliche Umschaltung zwischen verschiedenen Kontakten zum Test einer speziellen Ader ist fachüblich und soll hier nicht näher erläutert werden.

Der Kontakt des Ersatzprüfmoduls enthält eine Bürsteneinheit. In dieser ist ein jeweiliges Kontaktende des Kabelbaums aufnehmbar und elektrisch kontaktierbar, insbesondere wenn dieses als solches vorliegt (blanke Litze / verzinnt / ...) oder mit einem mechanisch empfindlichen Kontaktelement, jedoch ohne Steckverbindergehäuse eines Steckverbinders, bestückt ist. Die Bürsteneinheit weist elektrisch leitfähige Bürstenhaare zur elektrischen und dabei mechanisch schonenden Kontaktierung des Kontaktendes bzw. des Kontaktelements auf. Insbesondere handelt es sich hierbei um eine Bürsteneinheit, wie sie weiter unten ausführlich beschrieben wird.

Hintergrund hierzu ist folgender: Die Kontaktenden betreffender Leitungen, die - wie oben beschrieben - nicht mit einem komplettierten Steckverbinder versehen sind, sind dann z.B. als offene Litzen oder Drähte vorhanden. Alternativ sind an den Kontaktenden noch keine vollständigen Steckverbinder, sondern nur deren elektrische Kontaktelemente, nicht jedoch ein umgebendes Steckverbindergehäuse, angebracht. Diese Kontaktelemente sind also insbesondere Teile bzw. Einbauten von Steckverbindern (Buchsen oder Stecker). Die Kontaktelemente weisen z.B. feinste Blechstrukturen im Submillimeterbereich auf, z.B. sind dies sogenannte Crimpkontakte oder Stiftkontakte (siehe z.B. "Product-Information Crimp-Kontakte", Produktblatt (PDF), Werner Wirth GmbH, Hamburg, https:// www. wernerwirth. de/ fileadmin/ content/ bilder/ connect/ crimpcontakte_stanzbiegeteile/ crimp-kontakte/ Stiftkontakte/ werner_wirth_crimp_stiftkontakte.pdf, Abruf am 01.04.2021). Derartige Kontaktelemente sind mechanisch sehr empfindlich, d.h. können bereits durch kleine Kräfte beschädigt werden, wie sie z.B. bei einer herkömmlichen Klammerkontaktierung durch bekannte Prüfmodule auftreten. Erst durch die Aufnahme in einem Steckergehäuse werden die Kontaktelemente vor solchen Beschädigungen geschützt und mechanisch robust steckbar. Beim Kabelbaumtest sind die Steckverbindergehäuse aber gegebenenfalls noch nicht montiert oder z.B. noch gar nicht verfügbar (z.B. beim Prototypenbau). Die elektrische und mechanische Kontaktierung derartiger mechanisch empfindlicher Kontaktelemente ist problematisch, da einerseits ein guter elektrischer Kontakt zu diesen hergestellt werden muss, diese andererseits jedoch nicht mechanisch beschädigt werden dürfen.

Dank der Bürsteneinheit können insbesondere diese mechanisch empfindlichen Kontaktenden / Kontaktelemente beschädigungs- bzw. zerstörungsfrei und dennoch elektrisch ausreichend gut kontaktiert werden, d.h. mit einem ausreichend kleinen Übergangswiderstand zwischen Kontaktelement und Bürstenhaaren. Vorliegend wird zum Beispiel davon ausgegangen, dass der entsprechende Übergangswiderstand zwischen einem betrachteten Kontaktelement und einer hier verwendeten Bürsteneinheit typischerweise 2 Ohm bis 5 Ohm, jedoch keinesfalls mehr als 10 Ohm beträgt.

Das Ersatzprüfmodul enthält eine elektrische Hauptleitung. Diese Hauptleitung verbindet die Gegenschnittstelle mit dem Kontakt. Wie oben angesprochen, soll dabei eine wahlweise Verbindbarkeit mit einem von mehreren Kontakten außer Acht gelassen werden, die z.B. optional vorhanden ist, um eine aktuelle Prüfung einer bestimmten Ader an einem der Kontakte durchführen zu können. Falls zum Beispiel ein entsprechender Umschalter vorgesehen ist, um die Gegenschnittstelle wahlweise mit verschiedenen Kontakten zu verbinden, ist vorliegend unter der Hauptleitung jeweils diejenige zu verstehen, die auf den betreffenden einen oder mehrere der Kontakte aktuell durchgeschaltet ist. Im Betrieb des Testsystems ist die Hauptleitung dann gegebenenfalls von einem vom Testsystem erzeugten Messstrom durchflossen bzw. mit der erzeugten Testspannung beaufschlagt, um den Strom durch die Hauptleitung zu treiben.

Vorliegend wird davon ausgegangen, dass das Testsystem mit Strommessung und nicht mit Spannungsmessung arbeitet. Die vorliegende Erfindung ist jedoch sinngemäß auch auf ein mit Spannungsmessung arbeitenden Testsystem übertragbar. Zum Adertest wird also der Strom (Messstrom) gemessen, den das Testsystem (vermittels einer Strom- oder Spannungsquelle) durch die Ader - und damit die Hauptleitung - treiben kann. Der Messstrom kann dabei auch den Wert Null annehmen, wenn z.B. die aktuell zu messende Ader in fehlerhafter Weise elektrisch unterbrochen ist oder komplett fehlt. Bei der Strommessung wird der Ader also ein entsprechender Messstrom eingeprägt (falls möglich, also falls keine Aderunterbrechung) und vom Testsystem ausgewertet, ob der betreffende Messstrom tatsächlich in erwarteter Höhe fließt oder eben nicht. Entsprechend gibt das Testsystem für die Ader eine Meldung o.ä., wie z.B. "Leitung erkannt" oder "Leitung fehlt" aus. Eine bestimmungsgemäße bzw. ordnungsgemäße elektrische Kontaktierung der Kontaktenden / Kontaktelemente zu den Schnittstellen über die Prüfmodule / Ersatzprüfmodule wird dabei stets vorausgesetzt. Eine Fehlkontaktierung zwischen Kontaktende und Kontaktelement kann dabei jedoch insbesondere detektiert werden. Vorliegend wird unter dem "Messstrom" stets derjenige Anteil des Stromes in der Hauptleitung verstanden, der alleine durch das (in Bezug auf das Ersatzprüfmodul "externe") Testsystem bzw. dessen Strom- oder Spannungsquelle erzeugt ist.

Das Ersatzprüfmodul enthält einen Gutwert für den Messstrom. Dieser Gutwert ist auf das Testsystem bezogen, das heißt: Ein Messstrom mit diesem Gutwert wird vom Testsystem an einer betreffenden Auswertestelle sicher und bekannterweise als ausreichend hoch bewertet, damit die betreffende Ader als "gut" bzw. "durchgängig" bewertet wird ("Leitung erkannt"). Dabei muss nicht bekannt sein, ob und wenn ja, wie weit der Wert des Messstromes im Testsystem auch unterhalb des Gutwertes liegen darf, damit die Ader vom Testsystem immer noch als "durchgängig" bewertet wird. Auch muss nicht bekannt sein, unterhalb welchen Wertes des Messstromes die Ader im Testsystem als "fehlerhaft" bzw. "nicht durchgängig" ("Leitung fehlt") bewertet wird. Insofern ist der Gutwert vom Testsystem vorgebbar bzw. vorgegeben. Der Gutwert liegt verfügbar für das Ersatzprüfmodul vor, ist dabei zum Beispiel als Digitalwert in einem nicht näher erläuterten Speicher des Ersatzprüfmoduls abgelegt bzw. ablegbar und insbesondere veränderbar.

Das Ersatzprüfmodul enthält weiterhin einen vorgebbaren bzw. vorgegebenen Schwellwert für den Messstrom. Dieser Schwellwert ist auf das Ersatzprüfmodul bezogen. Der Schwellwert ist kleiner als der Gutwert. Der Schwellwert hat folgenden Hintergrund: Der Übergangswiderstand zwischen der Bürsteneinheit und dem Kontaktende / Kontaktelement, ist in der Regel größer als ein Übergangswiderstand, den ein konventionelles Prüfmodul des Testsystems zwischen Kontaktende / Kontaktelement und Prüfmodul aufweisen würde. Dieser erhöhte Übergangswiderstand, der vom Prüfsystem nicht erwartet wird, kann bei der Strommessung bzw. dem sich einstellenden Messstrom ins Gewicht fallen. Je nach Auslegung der im Testsystem verwendeten Strom- oder Spannungsquelle kann dies nämlich dazu führen, dass auch bei einer einwandfrei durchgängigen Ader, die über die Bürsteneinheit kontaktiert ist, ein Messstrom fließt, der unterhalb des vom Testsystem erwarteten internen Grenzwertes ("Leitung erkannt") und daher auch unterhalb des Gutwertes liegt. Ein derartiger Messstrom mit einer Größe unterhalb des Gutwertes könnte daher an sich zu einer fehlerhaften Entscheidung im Testsystem, nämlich "nicht durchgängig", für die betreffende an sich intakte Ader führen. Da der Umstand eines erhöhten Kontaktwiderstandes jedoch im Ersatzprüfmodul bekannt ist, kann in diesem ein - vom Testsystem ggf. abweichender - Schwellwert vorgegeben werden: Liegt der Messstrom dann oberhalb des Schwellwertes, ist hinsichtlich des Ersatzprüfmoduls bekannt, dass die Ader dennoch als "gut" bzw. "durchgängig" zu bewerten ist, obschon der Gutwert des Messstromes (bzw. Grenzwert, den das Testsystem erwartet) nicht erreicht ist. Durch die zusätzlichen, nachfolgend beschriebenen Maßnahmen wird dann erreicht, dass das Testsystem in diesem Fall dazu gebracht wird, stets die korrekte Bewertung "Leitung erkannt" auszugeben.

Das Ersatzprüfmodul enthält eine Steuer- und Auswerteeinheit bzw. Recheneinheit, im Folgenden kurz "Steuereinheit" genannt. Diese ist dazu eingerichtet, das Ersatzprüfmodul zumindest (also ggf. neben anderen Modi, siehe unten) in einem Aktivprüfmodus zu betreiben. In dem Aktivprüfmodus wird ein Istwert des vom Testsystem erzeugten bzw. verursachten Messstromes ermittelt, der durch die Hauptleitung bzw. durch das Ersatzprüfmodul fließt. Der Eintrittsort kann, je nach Anschlussort des Ersatzprüfmoduls am Testsystem bzw. der vom Testsystem erzeugten Stromrichtung des Messstromes im Ersatzprüfmodul an der Gegenschnittstelle oder dem gerade betriebenen Kontakt liegen, an dem die gerade zu testende Ader mit ihrem Kontaktende angeschlossen ist.

Für den Fall, dass der Istwert über dem Schwellwert, insbesondere zwischen dem Schwellwert und dem Gutwert liegt, wird dann an der Hauptleitung ein Summenstrom aus der Quelle des Fremdprüfsystems über die Gegenschnittstelle oder den Kontakt in das Ersatzprüfmodul eingezogen. Alternativ wird der Summenstrom in die Senke des Fremdprüfsystems über die Gegenschnittstelle oder den Kontakt aus dem Ersatzprüfmodul ausgegeben. Der Summenstrom stellt dabei stets die Summe aus dem Messstrom und einem Ergänzungsstrom dar. Die Eingabe / das Einziehen von Strom "an der Hauptleitung" ist dabei einer Eingabe dieses Stromes in das Ersatzprüfmodul gleichzusetzen. Die Ausgabe von Strom "an der Hauptleitung" ist dabei einer Ausgabe dieses Stromes aus dem Ersatzprüfmodul gleichzusetzen. Mit anderen Worten fließt der Messstrom unverändert durch das Ersatzprüfmodul hindurch und wird eingangsseitig oder ausgangsseitig ggf. um den Ergänzungsstrom additiv erhöht. Das jeweilige Ende, an dem der Summenstrom, also der um den Ergänzungsstrom erhöhte Messstrom entweder aus der Hauptleitung herausfließt oder in diese hineinfließt wird "Korrekturende" der Hauptleitung genannt. Das Korrekturende ist daher entweder der Kontakt oder die Gegenschnittstelle, je nachdem wo aktuelle die Eingabe / Ausgabe des Summenstromes erfolgt.

Das Korrekturende ist dasjenige Element (Kontakt oder Gegenschnittstelle) bzw. dasjenige Ende der Hauptleitung, das derjenigen Schnittstelle des Testsystems zugewandt ist, die zu einer Auswerteeinheit des Testsystems führt. Die Auswerteeinheit ist dasjenige Element im Testsystem, das die Strommessung des Teststromes / Messstromes durchführt. Die Erfindung beruht auf folgender Annahme, die anhand von Systemüberlegungen zur Funktionsweise von Testsystemen aufgefunden wurde: Vorliegend wird davon ausgegangen, dass bei einem Testsystem, welches mit einer Spannungsquelle arbeitetet, die Auswerteeinheit immer bei der Spannungsquelle und nie bei der Stromsenke liegt. Bei einem Testsystem, welches mit einer Stromquelle arbeitetet, wird davon ausgegangen, dass die Auswerteeinheit dagegen immer bei der Stromsenke und nie bei der Stromquelle liegt.

Der Summenstrom ist dabei aus dem Messstrom und einem in die Hauptleitung zusätzlich zum Messstrom (aus einer Stromquelle des Ersatzprüfmoduls) eingespeisten und am Korrekturende ausgegebenen Ergänzungsstrom zusammengesetzt. Dieser Fall wird stets genutzt, wenn das Fremdprüfsystem eine Stromquelle mit senkenseitiger Auswertung umfasst. Alternativ ist der Summenstrom aus einem am Korrekturende zusätzlich zum Messstrom eingezogenen und dann aus der Hauptleitung (zu einer Stromsenke des Ersatzprüfmoduls geführten) abgezweigten / abgezogenen / abgeleiteten Ergänzungsstrom zusammengesetzt. Dieser Fall wird stets genutzt, wenn das Fremdprüfsystem eine Spannungsquelle mit quellenseitiger Auswertung umfasst. Gegenüber dem Korrekturende, also am anderen Ende der Hauptleitung, tritt daher stets unverändert der Messstrom in die Hauptleitung ein oder aus dieser aus.

Der Ergänzungsstrom weist dabei einen vorgebbaren Ergänzungswert auf. Der Ergänzungswert ist dabei so dimensioniert, dass der Wert des zum Tester und damit zu dessen Auswerteeinheit zurückgelieferten oder aus dem Tester und damit der Auswerteeinheit gezogenen Summenstromes mindestens, insbesondere genau, den Gutwert annimmt. Damit wird sichergestellt, dass der Tester die betreffende Leitung als "gut" bzw. "durchgängig klassifiziert". Aufgrund der getroffenen Annahmen über das Testsystem (Spannungsquelle: immer Stromauswertung auf Seiten der Spannungsquelle oder Stromquelle: immer Auswertung auf Seiten der Stromsenke) kann so das Testsystem in allen Fällen durch den Ergänzungsstrom korrigiert werden. In anderen Fällen - von denen angenommen wird, dass Sie in der Praxis nicht vorkommen - könnte z.B. eine Korrektur ausscheiden: Dies wäre z.B. der Fall, wenn eine Stromquelle mit Stromauswertung in der Quelle eine Testleitung speist und diese erst stromabwärts durch die Bürste kontaktiert ist. Falls die Stromquelle nicht fähig ist, ausreichend Messstrom durch den Bürstenwiderstand zu treiben, kann in der Stromquelle / Auswerteeinheit durch das Ersatzprüfmodul kein weiterer Ergänzungsstrom entzogen werden, da der Bürstenwiderstand zwischengeschaltet ist. Hier wäre der Einsatz eines Ersatzprüfmoduls nicht möglich bzw. zwecklos. Mit anderen Worten wäre also der Messstrom auch durch das Ersatzprüfmodul nicht manipulierbar. Denn dann liegt die den gegebenenfalls problematischen Übergangswiderstand aufweisende Bürstenanordnung (in Richtung des Messstromes gesehen) eingangsseitig am Ersatzprüfmodul und damit unbeeinflussbar im Weg des Messtromes.

Ansonsten, d.h. wenn der im Ersatzprüfmodul in der Hauptleitung festgestellte Istwert des Messstromes unterhalb des Schwellwertes liegt, wird der Messstrom (auch am oben beschriebenen Korrekturende) an der Hauptleitung unverändert am Ersatzprüfmodul ausgegeben oder eingezogen, d.h. unverändert durch das Ersatzprüfmodul durchgeleitet, ohne Strom hinzuzufügen oder abzuzweigen. Mit anderen Worten wird dem Messstrom bzw. der Hauptleitung kein Ergänzungsstrom zu- oder abgeführt. Grund hierfür ist, dass davon ausgegangen wird, dass auch in Kenntnis des erhöhten Übergangswiderstandes an der Bürstenanordnung der Messstrom als zu gering beurteilt wird, als dass noch eine intakte Ader vorliegen würde. Die Beurteilung wird dann dem Testsystem überlassen, wobei davon auszugehen ist, dass auch das Testsystem diese Messung als "Leitung fehlt" erkennen wird. Insbesondere wird so auch vorgegangen, wenn der Istwert über dem Gutwert liegt.

Zusammenfassend wird also vorliegend von folgendem Tester ausgegangen: Dieser enthält zwei Schnittstellen. Eine "erste" der Schnittstellen ist versorgt aus einer Spannungs- oder Stromquelle des Testers. Diese legt an einem Kontaktende der Ader einen Messstrom an bzw. versucht, diesen in die Ader zu treiben. Die Ader endet mit ihrem anderen Kontaktende an der anderen "zweiten" Schnittstelle. Die andere Schnittstelle führt zu einer Stromsenke. Im Fall der Stromquelle findet die Strommessung im Testsystem in dessen Auswerteeinheit senkenseitig also stromabwärts der "zweiten" Schnittstelle statt.

Im Fall der Spannungsquelle findet eine Strommessung im Testsystem in dessen Auswerteeinheit quellenseitig also stromaufwärts der "ersten" Schnittstelle statt.

Kurz zusammengefasst: An jede der Schnittstellen wird also üblicherweise ein Prüfmodul angeschlossen, zwischen den Prüfmodulen wiederum wird der Kabelbaum so angeschlossen, dass dessen zu prüfende Adern jeweils zwischen zwei Prüfmodule und damit Schnittstellen geschaltet sind. Es ergibt sich also folgende Reihenschaltung: eine der Schnittstellen - Prüfmodul - zu testende Ader - Prüfmodul - andere Schnittstelle. Zum Test verschiedener Adern wird in den Prüfmodulen zwischen den Adern in hier nicht näher erläuterter Weise umgeschaltet. Vorliegend wird eines der Prüfmodule durch das Ersatzprüfmodul ersetzt und ansonsten unverändert getestet.

Hinsichtlich des Aktivprüfmodus und auch anderer Betriebsarten des Ersatzprüfmoduls (siehe unten) wird stets davon ausgegangen, dass das Ersatzprüfmodul ordnungsgemäß im Testsystem angeschlossen ist und das Testsystem auch einen entsprechenden Kabelbaumtest durchführt, also ordnungsgemäß Messstrom oder auch Messspannung (siehe auch unten) erzeugt. Denn wenn generell vom Testsystem überhaupt kein Messstrom / Messspannung erzeugt würde, wäre ein Betrieb des Ersatzprüfmoduls sinnlos.

Optional ist es auch denkbar, dass eine Ader an beiden Kontaktenden in einer Bürsteneinheit aufgenommen ist, die mit der vorliegenden Bürsteneinheit des Ersatzprüfmoduls vergleichbar ist. Diese kann durch ein eigenes Ersatzprüfmodul, ein vergleichbares rein passives Ersatzprüfmodul (ohne Möglichkeit zur Einspeisung / Abführung eines Ergänzungsstromes) oder eine sonstige Einheit gebildet sein, die mit einer Schnittstelle des Testers verbindbar ist und die Bürsteneinheit zur Aderkontaktierung aufweist. Für entsprechende Überlegungen zur Vorgabe des vorliegenden Schwellwertes müsste dann die Summe der Übergangswiderstände beider Bürsteneinheiten in Betracht gezogen werden, die dann im Falle einer Strommessung in der betreffenden Ader zwischen den Schnittstellen in Reihe mit der Ader geschaltet wären. Eine Spannungs- / Stromquelle im Testsystem müsste daher "gegen beide Übergangswiderstände" beider Bürsteneinheiten arbeiten bzw. den Messstrom über diese treiben. Der Schwellwert wäre demnach insbesondere weiter abzusenken.

Optional können im Ersatzprüfmodul auch weitere Kontakte zum herkömmlichen Anschluss von Adern, z.B. über Steckkontakte, vorgesehen werden. Je nach den dort zu erwartenden Übergangswiderständen wäre dann gegebenenfalls auch ein Ergänzungsstrom vorzusehen oder eben auch nicht, falls die Übergangswiderstände im Bereich der Übergangswiderstände der üblichen Prüfmodule liegen.

Zusammenfassend wird also bisher vorgeschlagen, den Messstrom durch das Ersatzprüfmodul zu leiten und gegebenenfalls in Stromrichtung um den Ergänzungsstrom erhöht an den Tester zurückzuliefern oder aus diesem abzuziehen. Vorausgesetzt wird dabei, dass das Testsystem mit einer Strommessung arbeitet, der Test des Kabelbaums also anhand einer (Durchgangs-) Strommessung erfolgt, die Spannungs- / Stromquelle zumindest kräftig genug ist, überhaupt einen nennenswerten Messstrom (im "Gut"-Fall einer Ader mindestens in Höhe des Schwellwertes) über den Kontaktwiderstand der Bürsteneinheit zu treiben und dass die Strommessung für eine Spannungsquelle stromaufwärts und für eine Stromquelle stromabwärts des Ersatzprüfmoduls stattfindet. Das Ersatzprüfmodul ist also ein solches, welches als Ersatz bzw. anstelle eines sonst üblichen Prüfmoduls an die Schnittstelle eines Testsystems anschließbar ist bzw. angeschlossen wird.

Die vorliegende Erfindung beruht auf folgenden Erkenntnissen und Überlegungen: Die Erfindung betrifft als Themengebiet bzw. Einsatzbereich die Überprüfung von Kabelbäumen, insbesondere sogenannte Prüftische, die aus der Praxis bekannt sind (siehe z.B. "Prüftische", Produktinformationen (Internetseite), TSK Prüfsysteme GmbH, Porta Westfalica, "https:// www. t-s-k. de/ de/ wire-harness-test-systems/ test-benches/", Abruf am 06.04.2021).

Als Anwendungsfall wird dabei insbesondere der Test von vorbestückten Kabelbäumen mit offenen Enden (Kontaktende mit Kontaktelement, aber ohne vollständigen Steckverbinder) betrachtet. Relevant ist dies zum Beispiel beim Kabelbaum-Prototypenbau mit fehlenden Steckverbinder-Gehäusen (da diese zum Beispiel noch nicht verfügbar sind) oder auch bei der Kabelbaum-Serienfertigung von Teil-Kabelbäumen (mit offenen Enden, da die Kontaktelemente noch nicht in die Steckverbinder-Gehäuse eingelegt sind).

Dabei besteht die Problematik einer schnellen Kontaktierung der offenen Leitungsenden (Kontaktelemente) ohne Kontaktbeschädigung (Beschädigung der Kontaktelemente).

Aus der Praxis ist es bekannt, offene Enden (Kontaktende) ohne Crimp-Kontakte (Kontaktelement) zu kontaktieren, nämlich durch die Nutzung von Einzel-Prüfmodulen (Klammer), was zeitraubend ist, und dem nachträglichen Anbringen der Kontakte (Kontaktelemente), was wiederum aufwendig ist.

Die vorgeschlagene Lösung basiert auf der grundlegenden Idee, ein Ersatzprüfmodul mit einer Kontaktbürste (Kohlefaserbürste zur schonenden Kontaktierung der Kontaktenden mit Kontaktelement) zu schaffen und gegebenenfalls eine Korrekturelektronik zu aktivieren, um gegebenenfalls einen um einen Ergänzungsstrom erhöhten Messstrom im Testsystem zu erzeugen. Eine Grundidee der Lösung ist es daher auch, dass das Ersatzprüfmodul "transparent" für Fremd-Prüfsysteme wird, d.h. dass sich das Gesamtsystem (Kabelbaum mit Kontaktelement / Aufnahme in Kohlefaserbürste mit gegebenenfalls erhöhtem Kontaktwiderstand) aus Sicht des Prüfsystems gleich verhält wie ein Kabelbaum mit vollständigem Stecker bei Einsatz eines für das Prüfsystem eigentlich vorgesehenen Prüfmoduls. Die "Transparenz" wird dabei durch die "Simulation" des erwarteten Messstromes, d.h. durch die Ergänzung um den Ergänzungsstrom, erreicht.

Die vorgeschlagene Lösung geht von folgendem aus: bei der Prüfung von Kabelbäumen auf Vollständigkeit und/oder Funktion der Adern des Kabelbaumes wird mit sogenannten Prüfmodulen die elektrische Verbindung zwischen den Aderanschlüssen und einem Kabelbaumtester hergestellt. Die Adern des Kabelbaumes sind in der Regel mit Kontakten (Kontaktelement) in den Gehäusen der Steckverbinder bestückt. Die Prüfmodule enthalten die Aufnahme (Gegen-Steckverbinder) der Steckverbinder und die Kontaktierung zum Kabelbaumtester (Schnittstelle). Die Prüfmodule sind elektrisch passiv, das heißt es gibt keine Vorzugsrichtung für die elektrischen Prüfsignale. Als Prüfsignale liefert der Tester aus einer Quelle eine Prüfspannung (z. B. 10V) bzw. einen Prüfstrom (zum Beispiel 20mA). Da sonst keine technischen Daten des Testers bekannt sind, wird davon ausgegangen, dass sich die Quellen ideal verhalten, d.h. Spannungsquelle mit einem Innenwiderstand, der gegen Null geht, Stromquelle mit einem Innenwiderstand, der gegen unendlich geht; Auswertung des Stromes durch einen vom Messstrom durchflossenen Strommesser im Testsystem, z.B. einem niederohmigen Shuntwiderstand. Die Auswertung stellt dabei das Vorhandensein und/oder die Funktion der Adern (insbesondere Durchgang oder nicht) fest.

In Sonderfällen ist es möglich, dass sich Aderkontakte (Kontaktelemente) zwar am Kontaktende einer Ader, jedoch noch nicht in einem Steckergehäuse befinden. Diese Kontaktelemente können daher nicht mit Hilfe eines Standard-Prüfmoduls (für Steckverbinder) mit dem Tester verbunden werden.

Zur Prüfung des Kabelbaumes wird für derartige Adern daher erfindungsgemäß ein spezielles Ersatzprüfmodul zur Verfügung gestellt, das in der Lage ist, zu einem einzelnen Aderkontakt eine elektrische Verbindung herzustellen, ohne diesen mechanisch zu beanspruchen. Für diesen Fall wird vorliegend eine Bürsteneinheit, insbesondere Kontaktbürste aus Kohlefasern, zur Verfügung gestellt, die den Aderkontakt "weich" aufnimmt und dabei eine niederohmige Verbindung zum Kabelbaumtester herstellt. Die wesentlichen Komponenten des Ersatzprüfmoduls sind dabei eine Kontaktbürste zur Aufnahme des Aderkontaktes, eine Messelektronik für Strom- und gegebenenfalls Spannungsmessung, eine Rechen- und Steuereinheit.

Idee ist es dabei, dass das Ersatzprüfmodul bidirektional arbeitet, d.h. Quelle und Senke können vertauscht werden (Einsatz an beiden Schnittstellen möglich, ohne zu wissen, wo sich im Prüfsystem intern Quelle und Senke befinden).

Der hier vorgeschlagenen Lösung liegt weiterhin die Idee zugrunde, optional eine Kalibrierung im Ersatzprüfmodul durchzuführen. Sinn und Ziel dieser Kalibrierung werden im Folgenden beschrieben:
Es wird dabei angenommen, dass eine Spannungsquelle oder Stromquelle beim Fremdprüfsystem für das Ersatzprüfmodul nur dann unkritisch ist, d.h. keine relevante Beeinflussung der Spannungs- / Strommessung aufgrund des relativ niedrigen KontaktWiderstandes der Ersatzprüfmodul-Bürste (typisch 2 bis 5 maximal 10 Ohm) stattfindet, wenn diese in der Lage ist Strom ausreichend kräftig auch über die Bürsteneinheit zu treiben. Hieraus folgt, dass in diesem Fall das Ersatzprüfmodul ohne den Einsatz weiterer Elektronik, also in einem Passivprüfmodus verwendbar ist. Der Messstrom bzw. die Messspannung kann also ohne Modifikation, insbesondere ohne Zuspeisung / Ableitung eines Ergänzungsstromes, durch das Ersatzprüfmodul hindurch geführt werden.

Eine Spannungs- oder Stromquelle beim Fremdprüfsystem könnte dagegen auch eventuell kritisch sein, weil der bis zu 10 Ohm große Widerstand (Übergang vom Kontaktende / Kontaktelement zur Kontaktbürste) bei einer leistungsschwachen Quelle (z.B. hoher Innenwiderstand) zu einer Reduzierung des Messstromes durch eine an sich intakte, vorhandene Kabelbaum-Leitung bzw. Ader führen kann. Dies würde damit zu einer fälschlichen Nichterkennung der Ader im Fremdprüfsystem führen, obschon die Abschwächung des Stromes nicht durch die (fehlerfreie) Ader selbst, sondern durch die Bürsteneinheit des Ersatzprüfmoduls erzeugt ist. In diesem Fall würde sich eine fehlerhafte Meldung des Fremdprüfsystems ergeben.

Hierdurch ergeben sich folgende Kalibrierungsziele:
1.) Folgendes ist bezüglich des Fremdprüfsystems durch die Kalibrierung zu klären: Klärung zur Quellenart, d.h. Detektion, ob das Fremdprüfsystem eine Spannungsquelle oder eine Stromquelle einsetzt. Klärung zur Stromrichtung, in der das Ersatzprüfmodul durchflossen wird, befindet sich die Quelle also seitens des Kontaktes oder der Gegenschnittstelle. Eine Klärung zur Messanordnung ist an sich nicht nötig, denn es wird davon ausgegangen, dass bei einer Spannungsquelle die Stromauswertung quellenseitig, bei der Stromquelle senkenseitig erfolgt. Dennoch könnte eine solche Klärung durchgeführt werden: Es könnte also insbesondere ermittelt werden, ob die Ergebnismessung im Fremdprüfsystem durch Messung des Stroms auf Seiten der Quelle oder auf Seiten der Senke erfolgt. Damit könnten zumindest die vorliegend getroffenen Annahmen verifiziert werden. Klärung zum Messwertlevel (Strom- Messwert im Fremdprüfsystem und/oder Ersatzprüfmodul) unter verschiedenen Bedingungen, d.h. bei Normalbedingungen (der Widerstand im Ersatzprüfmodul beträgt dabei Null Ohm, Verhalten wie Standard-Prüfmodul) und bei dem schlechtesten anzunehmenden, jedoch planmäßigen Kontakt (der Widerstand im Ersatzprüfmodul beträgt z.B. nicht mehr als 10 Ohm, zur Sicherheit also Einsatz eines 10 Ohm-Widerstandes).
2.) Weiterhin soll eine Ableitung der Einsatzmöglichkeiten und des Einsatzmodus des Ersatzprüfmoduls ermittelt werden. In einer Variante 1 (Passivprüfmodus) erfolgt der Einsatz des Ersatzprüfmoduls ohne Einsatz der Korrekturelektronik (keine bzw. niemals Zuspeisung / Ableitung eines Ergänzungsstroms), in einer Variante 2 (Aktivprüfmodus) erfolgt der Einsatz des Ersatzprüfmoduls mit Korrektur-Elektronik (Prüfung des Messstromes und ggf. Zuspeisung / Ableitung eines Ergänzungsstroms). In einer Variante 3 (Meldemodus) soll entschieden werden, dass der Einsatz des Ersatzprüfmoduls nicht möglich / nicht sinnvoll erscheint (z.B. für die oben erläuterte Konfiguration mit leistungsschwacher Strom- / Spannungsquelle, die schlicht nicht in der Lage ist, überhaupt nennenswert Strom über das Ersatzprüfmodul zu treiben).

Voraussetzungen für die Kalibrierung ist, dass das Ersatzprüfmodul im Messpfad des Fremdprüfsystems eingebaut bzw. angeschlossen ist, wobei eine bekannt durchgängige Ader bzw. eine entsprechende Kalibierverbindung zwischen dem Ersatzprüfmodul und der gegenüber liegenden Schnittstelle eingesetzt ist (bekannte Kalibrier-Widerstände z.B. Null und 10 Ohm). Weitere Voraussetzung ist, dass das Fremdprüfsystem seine Messung startet und das Ergebnis auswertet sowie - optional, falls nötig - dass dieses vom Testsystem ermittelte Ergebnis im Kalibrierverfahren verwendet werden kann (Kommunikationsmöglichkeit vom Fremdprüfsystem zum oder Eingabemöglichkeit am Ersatzprüfmodul). Optional ist es hier auch denkbar, dass das Ersatzprüfmodul eine solche Eingabemöglichkeit nicht aufweist und ein menschlicher Systemprüfer die Situation nach den hier geschilderten Ergebnissen / Erkenntnissen auswertet und einen geeigneten Betriebsmodus für das Fremdprüfmodul wählt bzw. ein Ersatzprüfmodul wählt, das fest für den betreffenden Betriebsmodus konfiguriert ist.

Durch das Einsetzen verschiedener Kalibrierwiderstände zwischen den Schnittstellen des Fremdprüfsystems, Messung des zwischen den Schnittstellen in bestimmten Situationen fließenden Stromes und optional die jeweilige Kenntnis der Auswertung des Messergebnisses am Fremdprüfsystem ("Leitung erkannt / durchgängig" oder "Leitung nicht erkannt / nicht durchgängig") können in einem sukzessiven Kalibrierverfahren die obigen Kalibrierziele geklärt werden. Für eine detaillierte Beschreibung des Verfahrens siehe weiter unten.

Der Aktivprüfmodus eignet sich insbesondere dann, wenn das Fremdprüfsystem mit Stromquelle oder Spannungsquelle arbeitet und bei Anlegen eines Kalibrierwiderstandes (Maximalwiderstand, z.B. 10 Ohm) im Messpfad zwischen Ersatzprüfmodul und gegenüberliegender Schnittstelle bei ansonsten bekannt guter Leitung der Messstrom größer Null, jedoch kleiner dem Strom-Gutwert ist (Strom-Gutwert: Istwert des Messstromes bei Kalibrierwiderstand Null und bekannt guter Leitung). In diesem Fall ist die Strom- / Spannungsquelle im Fremdprüfsystem nicht stark genug, um den Messstrom in unverminderter Stärke über den maximal zu erwartenden Kontaktwiderstand der Kontaktbürsten zu treiben; dennoch fließt ein nennenswerter Strom, z.B. mindestens 5 mA, aber es erfolgt eine Abschwächung des Messstromes gegenüber dem Strom-Gutwert, obschon eine an sich einwandfreie zu testende Leitung vorliegt.

In einer bevorzugten Ausführungsform entspricht der Ergänzungswert der Differenz von Gutwert und Schwellwert oder der Differenz von Gutwert und Istwert. Somit wird erreicht, dass dem Prüfsystem stets der Messstrom in Höhe mindestens (Gutwert minus Schwellwert) oder genau (Gutwert minus Istwert) des Gutwertes zugeführt wird, sobald der Istwert des Messstromes über dem Schwellwert liegt.

In einer bevorzugten Ausführungsform ist die Steuereinheit dazu eingerichtet, das Ersatzprüfmodul auch in einem Passivprüfmodus zu betreiben. Im Passivprüfmodus wird der Messstrom mit seinem Istwert stets unverändert durch das Ersatzprüfmodul bzw. durch die Hauptleitung durchgeleitet. "Unverändert" bedeutet dabei, dass der Messstrom nicht aktiv durch Zuspeisung / Ableitung eines Ergänzungsstromes verändert wird. Beeinflussungen, die der Messstrom durch Elektronik / Bauteile im Ersatzprüfmodul erfährt, sollen hierbei außer Betracht bleiben. Hierzu zählen zum Beispiel eine Beeinflussung des Messstromes dadurch, dass dieser durch einen vergleichsweise niederohmigen Shuntwiderstand einer Strommessanordnung fließt, durch Dioden oder Halbleiterschalter fließt, die im Ersatzprüfmodul integriert sind, insbesondere in dessen Hauptleitung. Auch eine Spannung wird in diesem Sinne unverändert über die Hauptleitung übertragen, Spannungsabfälle an entsprechend oben genannten Bauteilen bleiben dabei außer Betracht. Der Passivprüfmodus eignet sich insbesondere, wenn das Testsystem (Fremdprüfsystem) eine Spannungsquelle oder Stromquelle verwendet und bei eingeschaltetem maximalem Kalibrierwiderstand der Messstrom unverändert dem Gutwert entspricht. In diesem Fall ist die Stromquelle im Fremdprüfsystem stark genug, um den Messstrom in unverminderter Stärke auch über den maximal zu erwartenden Kontaktwiderstand der Kontaktbürsten zu treiben. Es ergibt sich also kein Unterscheid zu einem herkömmlichen Prüfmodul, eine Korrektur im Ersatzprüfmodul ist überflüssig.

In einer bevorzugten Ausführungsform ist die Steuereinheit dazu eingerichtet, das Ersatzprüfmodul auch in einem Meldemodus zu betreiben. In diesem gibt das Ersatzprüfmodul eine Meldung aus, die anzeigt, dass ein Einsatz des Ersatzprüfmoduls mit dem Testsystem bzw. Fremdprüfsystem nicht sinnvoll bzw. nicht möglich ist. Der Meldemodus eignet sich insbesondere dann, wenn das Fremdprüfsystem mit einer Stromquelle arbeitet, die Strommessung jedoch auf der Strom-Quellenseite im Tester stattfindet und eine Beeinflussung durch Zuspeisung / Ableitung von Ergänzungsstrom im Ersatzprüfmodul ohne Auswirkung auf das Messergebnis des Fremdprüfsystems bleibt. Der aus dem Fremdprüfsystem gezogene Strom kann insbesondere durch das vorgeschlagene Ersatzprüfmodul nämlich nicht verändert werden, wenn dieses in Stromrichtung der zu messenden Ader nachgeschaltet ist. Der Meldemodus eignet sich auch an einem Testsystem, dessen Stromquelle zu schwach ist, um bei Einschaltung eines Kalibrierwiderstandes in eine ansonsten bekannt gute Ader überhaupt einen vom Ersatzprüfmodul messbaren Strom (Mindestwert, z.B. wenigstens 5mA) durch die Bürstenanordnung zu treiben. Eine Ausgabe der Meldung (optisch / akustisch / Nachricht / ...) erfolgt zum Beispiel über eine Anzeigeleuchte / Display oder eine Schallquelle, insbesondere am Ersatzprüfmodul, das Absetzen einer Kommunikationsnachricht an eine Gegenstelle, usw.

In einer bevorzugten Ausführungsform ist die Steuereinheit dazu eingerichtet, das Ersatzprüfmodul auch in einem Diagnosemodus zu betreiben. In diesem Modus ermittelt das Ersatzprüfmodul Eigenschaften eines angeschlossenen Testsystems bzw. Testers, ggf. mit angeschlossenem Prüfmodul des Fremdprüfsystems. Basierend auf diesen Eigenschaften ermittelt es weiterhin, ob im Ersatzprüfmodul in Verbindung mit dem Testsystem nach Beendigung des Diagnosemodus der Aktivprüfmodus oder - falls vorhanden - der Passivprüfmodus oder -falls vorhanden - der Meldemodus als ein Folgemodus gewählt werden soll. Folgemodus ist derjenige Modus, der dann bei der aktuellen Konfiguration des Ersatzprüfmoduls in bzw. an einem aktuell gewählten Fremdprüfsystem für den tatsächlichen Einsatz des Ersatzprüfmoduls gewählt werden sollte oder gewählt wird. Insbesondere ist die Steuereinheit auch dazu eingerichtet, nach Ermittlung des Folgemodus den Diagnosemodus zu beenden und das Ersatzprüfmodul in den betreffenden Folgemodus umzuschalten. Der Diagnosemodus, insbesondere in Verbindung mit den drei anderen Modi, führt dazu, dass das Ersatzprüfmodul auch ohne "externes" Wissen bzw. Kenntnisse über das Fremdprüfsystem, an dem das Ersatzprüfmodul betrieben werden soll, eingesetzt werden kann. Das Ersatzprüfmodul ermittelt also seine Einsatzmöglichkeiten selbst. Die "Eigenschaften des Testsystems" sind solche Kenngrößen, die mit dem Arbeits- / Mess- / Entscheidungsprinzip des Ersatzprüfmoduls in Verbindung stehen, wie es hier erläutert wird, die dessen Einsatz ermöglichen oder nicht und dessen Betriebsmodi bestimmen bzw. erlauben oder nicht. Die Eigenschaften sind insbesondere: die Stromrichtung des Messstromes und/oder die Quellentechnik (Strom- oder Spannungsquelle) im Testsystem und/oder die Anordnung der Auswerteeinheit bzw. Messstelle (quellen- oder senkenseitig) im Testsystem und/oder der Gutwert des Messstromes, bei dem das Testsystem eine Ader sicher als "durchgängig" meldet.

In einer bevorzugten Ausführungsform enthält die Hauptleitung im Ersatzprüfmodul ein Messmodul zur Strommessung des in der Hauptleitung fließenden Stromes. Das Messmodul enthält insbesondere einen Shuntwiderstand mit beidseitigem Spannungsabgriff und eine damit verbundene Spannungsmesseinheit. Der Istwert des aktuell in der Hauptleitung fließenden Messstromes kann damit sowohl für Kalibrierzwecke als auch beim Betrieb besonders einfach ermittelt werden.

In einer bevorzugten Variante dieser Ausführungsform ist das Messmodul wahlweise auch zur Spannungsmessung eingerichtet. Insbesondere soll die Spannung zwischen einem Messpunkt an der Hauptleitung und einem Bezugspotential, insbesondere Masse, ermittelt werden. Dies ist so zu verstehen, dass wahlweise eine Strom- oder Spannungsmessung im Ersatzprüfmodul, insbesondere an der Hauptleitung, insbesondere an einem dort vorhandenen Shunt-Widerstand, erfolgen kann. Insbesondere ist die Spannungsmessung bzw. eine betreffende Messeinrichtung einseitig am o.g. Shuntwiderstand vorgesehen, insbesondere für eine Messung der Spannung zu einem Bezugspotential, z.B. Masse. Insbesondere kann so auch das oben genannte Kalibrierverfahren besonders einfach mit dem Messmodul umgesetzt werden. Die Spannungsmessung kann insbesondere im Diagnosemodus verwendet werden, z.B. um den Ort der Auswerteeinheit (quellen- oder senkenseitig) zu ermitteln. Für die Annahme einer Spannungsquelle mit quellenseitiger und Stromquelle mit senkenseitiger Strom-Auswertung ist diese Ausführungsform insbesondere uninteressant bzw. wird nicht benötigt.

In einer bevorzugten Variante dieser Ausführungsform enthält die Hauptleitung beidseitig des Messmoduls eine jeweilige Stromweiche. Beide Stromweichen sind dazu eingerichtet, eine Stromrichtung in der Hauptleitung vorzugeben. So kann Strom in der Hauptleitung nur in einer bestimmten Richtung zwischen Kontakt und Gegenschnittstelle fließen. So kann die Stromrichtung vorgegeben werden, in der ggf. ein Ergänzungsstrom in der Hauptleitung fließen kann. Durch Umschaltung der Weichen kann die Richtung geändert werden, um das Ersatzprüfmodul für beliebige Verschaltungsorte im Testsystem zu ertüchtigen. Das Ersatzprüfmodul kann somit bidirektional, also an einer beliebigen Schnittstelle des Fremdprüfsystems eingesetzt werden. Je nach vom Testsystem vorgegebener Stromrichtung kann das Ersatzprüfmodul reagieren.

In einer bevorzugten Ausführungsform zweigt von der Hauptleitung wenigstens eine Stichleitung ab, die zu einer Stromquelle oder Stromsenke für den Ergänzungsstrom führt. Die Stichleitung ist zu einer wahlweisen Ableitung des Messstromes aus der Hauptleitung ausgebildet. Alternativ ist die selbe oder zusätzlich eine andere Stichleitung zu einer wahlweisen Einspeisung des Messstromes in die Hauptleitung ausgebildet. Unter einer "wahlweisen" Ableitung ist zu verstehen, dass eine vollständige Ableitung des Messstromes und/oder eine teilweise und/oder keine Ableitung, insbesondere eine vollständige oder keine Ableitung, erfolgen kann. Entsprechendes gilt für Stichleitungen, die zu einer wahlweisen Einspeisung ausgebildet sind. Die Wahlmöglichkeit ist insbesondere durch ein Schaltelement realisiert, welches insbesondere in der Stichleitung vorhanden ist (Auftrennung oder Durchverbindung der Stichleitung). Die Stichleitungen enthalten insbesondere Widerstände zur Begrenzung / Einstellung des Ergänzungswertes des Ergänzungsstromes. Ein solcher Widerstand ist insbesondere veränderlich / einstellbar ausgeführt.

In einer bevorzugten Ausführungsform enthält wenigstens eine der Stichleitungen eine Messeinheit für den dort (aktuell) fließenden Ergänzungsstrom. So kann der Ergänzungswert in dieser Stichleitung kontrolliert bzw. eingestellt / geregelt werden.

In einer bevorzugten Ausführungsform ist wenigstens eine der Stichleitungen aus wenigstens einer der Stromweichen abgezweigt. So kann je nach (vom Fremdprüfsystem bedingter) Stromrichtung des Messtromes in der Hauptleitung der eingespeiste oder abgezogene Ergänzungsstrom besonders einfach in die betreffend richtige Richtung in der Hauptleitung, also zum Korrekturende hin gespeist / von diesem weg gezogen werden.

In einer bevorzugten Ausführungsform zweigt von der Hauptleitung eine die Bürsteneinheit überbrückende Kalibrierleitung ab, die an einem Kalibrierkontakt endet. Durch Anschluss einer elektrischen Leitung am Kalibrierkontakt, zum Beispiel einer bekannt guten bzw. durchgängigen Kalibrierleitung, welche von der dem Ersatzprüfmodul gegenüberliegenden Schnittstelle kommt, kann so die Bürsteneinheit zu Kalibrierzwecken umgangen werden, um so definierte bzw. für eine Kalibrierung bekannte Widerstandsverhältnisse im bzw. am Fremdprüfsystem herzustellen, d.h. die Kontaktverhältnisse in einer Bürsteneinheit zu simulieren (z.B. best case / worst case).

In einer bevorzugten Variante dieser Ausführungsform enthält die Kalibrierleitung einen umschaltbaren oder veränderbaren Kalibrierwiderstand. Der Kalibrierwiderstand kann dabei insbesondere die Werte Null Ohm und einen maximal zu erwartenden Übergangswiderstand der Bürstenanordnung, insbesondere 10 Ohm annehmen. Somit können in einem Kalibrierverfahren durch Umschaltung (zwischen mehreren diskreten Werten) bzw. (kontinuierliche) Veränderung des Widerstandes ein idealer Kontakt des Ersatzprüfmoduls mit der Ader (vergleichbar mit dem Einsatz eines Prüfmoduls anstelle eines Ersatzprüfmoduls, "best case") oder ein "schlechtester" Kontaktwiderstand zwischen Ader und Ersatzprüfmodul über die Bürsteneinheit ("worst case") simuliert werden.

In einer bevorzugten Ausführungsform weist das Ersatzprüfmodul eine Eingabeschnittstelle auf, um eine Meldung vom Testsystem / Tester empfangen zu können, mindestens ob dieses eine aktuell getestete Ader als durchgängig ("Leitung erkannt") oder nicht durchgängig ("Leitung fehlt") bewertet. "Mindestens" heißt, dass optional auch noch andere Informationen empfangen werden können. Die Rückmeldung ist insbesondere das Messergebnis des Testsystems für eine aktuell geprüfte Ader, also "Leitung erkannt" oder "Leitung fehlt". Eine derartige Eingabeschnittstelle eignet sich insbesondere für den oben genannten Diagnosemodus, wenn es zur Diagnose erforderlich ist, ob bei einem gegebenen Verfahrensschritt das Testsystem eine durchgängige Ader detektiert oder nicht. Auch in anderen Fällen kann jedoch die Rückmeldung hilfreich sein.

Die Aufgabe der Erfindung wird auch gelöst durch ein Verfahren gemäß Patentanspruch 14 zum Testen mindestens einer elektrischen Ader eines Kabelbaums, wie sie oben erläutert wurde, mit Hilfe des erfindungsgemäßen Ersatzprüfmoduls und des Testsystems bzw. Testers wie er oben erläutert wurde, wobei die Ader das mindestens eine Kontaktende, ggf. mit dem Kontaktelement aufweist, das insbesondere mechanisch empfindlich ist. Das Verfahren weist folgende Schritte auf: Das Ersatzprüfmodul wird - insbesondere anstelle eines bestimmungsgemäß für das Testsystem vorgesehenen Prüfmoduls - in elektrischer Reihenschaltung mit der Ader zwischen die Schnittstellen geschaltet, wobei das Kontaktende bzw. das Kontaktelement in der Bürsteneinheit aufgenommen und elektrisch kontaktiert wird. Die Ader wird mit Hilfe des Testsystems bzw. Testers auf elektrische Durchgängigkeit ("Leitung erkannt" oder "Leitung fehlt") geprüft.

Das Verfahren und zumindest ein Teil dessen möglicher Ausführungsformen sowie die jeweiligen Vorteile wurden sinngemäß bereits im Zusammenhang mit dem erfindungsgemäßen Ersatzprüfmodul erläutert.

Insbesondere können auch Kabelbäume mit zwei oder mehr mechanisch empfindlichen Kontaktenden / Kontaktelementen überprüft werden: Dann erfolgt auch für diese eine entsprechende Bürstenkontaktierung. Die mechanische Empfindlichkeit ergibt sich insbesondere dadurch, dass an einem Kontaktende (Litzenende / Aderende) ein mechanisch empfindliches Kontaktelement (Aderkontakt, Crimpkontakt, ...) angebracht ist. Der zu prüfende Kabelbaum kann viele Adern bzw. Leitungen enthalten, die sich auch verzweigen etc. Für den Test wird jedoch immer eine der (Teil-)Leitungen auf Durchgang von einem ersten zu einem zweiten Kontaktende geprüft. Dieses "Ende" kann auch mittig in einer Leitung sein, dann wird der Leitungsabschnitt bis zu diesem "Ende" getestet. Der Kabelbaum kann dabei auch herkömmlich mit Steckkontakten versehene Enden aufweisen. Entweder werden hierfür entsprechend vorgesehene Prüfmodule des Testsystems an der Schnittstelle oder weiteren Schnittstellen verwendet oder am Ersatzprüfmodul werden weitere Kontakte vorgesehen, die herkömmlich zur Verbindung mit entsprechenden Steckern des Kabelbaumes ausgebildet sind. Für diese Adern bzw. Steckverbinder muss dann keine entsprechende Stromkorrektur (Aktivprüfmodus) erfolgen.

In einer bevorzugten Ausführungsform wird vor Beginn des Testens der Ader das Ersatzprüfmodul (in den entsprechend oben geschilderten Ausführungsformen, die den Kalibrierkontakt und ggf. die betreffenden Modi etc. aufweisen) mit einer der Schnittstellen verbunden, der Kalibrierkontakt über einen bekannt durchgängigen elektrischen Leiter oder dergleichen d.h. eine "Kalibrierleitung", mit der anderen Schnittstelle verbunden, und das Ersatzprüfmodul im Diagnosemodus und anschließend im während dieser Diagnose ermittelten Folgemodus betrieben. Damit ergeben sich die oben genannten Vorteile, dass zum Beispiel keine Vorkenntnisse über das Fremdprüfsystem notwendig sind, um das Ersatzprüfmodul zu betreiben und gegebenenfalls den Kabelbaumtest im Aktivprüfmodus und/oder Passivprüfmodus durchzuführen oder im Meldemodus anzuzeigen, dass der Einsatz des Ersatzprüfmoduls in diesem Fall nicht erfolgen sollte.

In einer bevorzugten Variante dieser Ausführungsform wird im Diagnosemodus vom Ersatzprüfmodul:
- a) ermittelt ob das Testsystem mit einer Spannungs- oder Stromquelle arbeitet, und ob das Korrekturende durch den Kontakt oder die Gegenschnittstelle gebildet ist; d.h. zu welcher Seite des Ersatzprüfmoduls in dessen aktueller Einbaulage im Testsystem die Auswerteeinheit zu finden ist.
   Insbesondere könnte an dieser Stelle optional auch geklärt / verifiziert werden, ob im Testsystem das erwartete Strommessverfahren oder ein Spannungsmessverfahren verwendet wird. Weiterhin könnte geklärt / verifiziert werden, ob im Testsystem die erwartete Strom- oder gegebenenfalls eine Spannungsmessung an der stromquellen- oder an der stromsenkenseitigen Seite des Testsystems erfolgt.
- b) der Istwert des bei einem Wert des Kalbrierwiderstandes von Null (effektiver Widerstand zwischen Schnittstelle und Hauptleitung über die Kalibrierleitung, egal wo der Widerstand angeordnet ist) fließenden Messstromes als Gutwert ermittelt, und
- bei einem vorgebbaren Wert des Kalibrierwiderstandes, der größer (insbesondere doppelt so hoch) oder gleich dem zu erwartenden üblichen bzw. maximalen Kontaktwiderstand in der Bürstenanordnung (zwischen Ader und Bürstenanordnung) ist, der Istwert des Messstromes ermittelt, und
- falls der Istwert unterhalb eines vorgebbaren Minimalwertes (z.B. 5%, 10%, 15%, 25% des Gutwertes, insbesondere Wert, bei dem eine für eine zuverlässige Messung ausreichende Stromleitung durch die Ader nicht mehr sichergestellt werden kann) liegt, der Meldemodus als Folgemodus gewählt,
- falls der Istwert (bis auf eine annehmbare fachübliche Toleranz, z.B. 1%, 5%, 10%, 25%) dem Gutwert entspricht, der Passivprüfmodus als Folgemodus gewählt,
- ansonsten der Istwert als Schwellwert verwendet und der Aktivprüfmodus als Folgemodus gewählt.

Somit erfolgt eine vollständige automatische Diagnose des Fremdprüfsystem, die Auswahl des entsprechenden Folgemodus und somit ein universell möglicher Einsatz des Ersatzprüfmoduls an einem Fremdprüfsystem.

In einer bevorzugten Ausführungsform könnte die Auswahl für / Entscheidung über den überhaupt möglichen Einsatz des Ersatzprüfmoduls / die Wahl des Betriebs-Modus auch durch einen menschlichen Bediener erfolgen, der sich in Kenntnis der Eigenschaften des Ersatzprüfmoduls / Testers an den Gegebenheiten im Einsatzfall orientiert.

Insbesondere könnten die bisher beschriebenen Aspekte der Erfindung ergänzend noch mit folgenden Aspekten einer Stecküberwachung / Schutzschaltung wie folgt kombiniert werden.

Insbesondere könnten die Aspekte Stecküberwachung / Schutzschaltung jedoch auch generell - also ohne Ersatzprüfmodul - an einem Testsystem eingesetzt werden.

Der Aspekt Stecküberwachung / Schutzschaltung beruht auf folgenden Überlegungen: Die Bürstenhaare der Kontaktbürsten / Bürsteneinheiten sind empfindlich. Falls z.B. ein Kontaktende des Kabelbaums zu fest / mit zu starkem Druck an die Bürstenhaare angedrückt wird, können diese beschädigt oder zerstört werden. Bürstenhaare können sich aus der Bürsteneinheit lösen und im Kabelbaum / Testsystem zu Störungen, z.B. Kurzschlüssen, führen. Die Bürstenhaare einer Kontaktbürste sind insbesondere parallel ausgerichtet d.h. zu einer Bürste nach Art eines Pinsels gebündelt. Z.B. sind die Bürstenhaare in einer Hülse, z.B. einer Aderendhülse gepresst bzw. geklemmt. So sind dies zur Bürste nach Art eines Pinsels gebildet.

Die Kontaktenden werden bestimmungsgemäß in einer Steckrichtung an die Bürste herangeführt, um diese zu kontaktieren. Die Steckrichtung verläuft insbesondere parallel zu den Bürstenhaaren; es erfolgt also eine stirnseitige Kontaktierung der Bürste. Die Bürsten / - haare sind also insbesondere so ausgerichtet, dass eine bestimmungsgemäße Anlagerichtung für die Kontaktenden in Richtung der Bürstenhaare bzw. deren Spitzen / Enden erfolgt. Wenn die Ader / das Kontaktende bestimmungsgemäß elektrisch kontaktierend an der Bürste anliegt, wird dies als "Steckzustand" des Kontaktendes bezeichnet

Grundidee des Aspekts Stecküberwachung ist hier eine Kontakt- / Berührungs- / Stecküberwachung für die Kontaktbürsten mit Hilfe des Schließens eines Schutzstromkreises. Hierbei wird erkannt, wenn ein Kontaktende beim Heranführen an die Bürste diese gerade ausreichend berührt, um elektrischen Kontakt herzustellen, ohne zu viel Druck auf diese auszuüben. So wird der Kontakt erkannt, bevor z.B. ein übermäßiges Verbiegen / Stauchen der Bürstenhaare eintritt oder z.B. das Kontaktende in die Bürste eindringt, also zwischen die Bürstenhaare eingeschoben wird.

Hierzu wird insbesondere vorgeschlagen: Ein galvanisch vom Testsystem und / oder Ersatzprüfmodul getrennter Schutzstromkreis, der wie folgt aufgebaut ist: Dieser weist ein erstes Ende auf, welches mit derjenigen Bürste bzw. den Bürstenhaaren elektrisch leitfähig verbindbar oder verbunden ist, an welche das Kontaktende anzulegen ist. Der Schutzstromkreis weist ein zweites Ende auf. Zwischen erstem Ende und zweitem Ende sind in Reihenschaltung eine Spannungsquelle (hier breit zu verstehen, es kann sich auch um eine Stromquelle handeln) und eine Strommesseinheit (auch breit zu verstehen, es kann auch eine Spannungs- / impedanzmesseinheit) angeschlossen. Auch die "Messeinheit" ist hier weit zu verstehen. Eine Messung im klassischen Sinne einer Wertbestimmung muss nicht stattfinden, es genügt die Feststellung, ob der Schutzstromkreis geschlossen oder geöffnet ist. Diese kann also einen Stromfluss erkennen, der durch das Schließen des Schutzstromkreises über das bestimmungsgemäß angelegte Kontaktende erfolgt. Die Spannungsquelle sorgt hierbei für das Treiben des Stromes durch den Schutzstromkreis.

Das zweite Ende ist in Relation zur Bürste / den Bürstenhaaren so anordenbar oder angeordnet bzw. dazu eingerichtet, dass bei der bestimmungsgemäßen Anlage des Kontaktendes an den Bürstenhaaren das Kontaktende auch das zweite Ende des Schutzstromkreises kontaktiert. Im Fall des bestimmungsgemäßen Anliegens des Kontaktendes an den Bürstenhaaren bzw. der Bürste / Bürsteneinheit ist somit über das Kontaktende eine elektrisch leitfähige Verbindung zwischen erstem und zweitem Ende des Schutzstromkreises bildbar bzw. wird gebildet, d.h. dieser geschlossen. Dabei wird das Kontaktende als soweit nötig in seinen Dimensionen und eletkrischen Eigenschaften bekannt vorausgesetzt, dass ein ausreichender Stromfluss im Schutzstromkreis fließen kann, der den ordnungegemäßen Steckzustand / Kontakt im Prüfsystem wiederspiegelt.

Mit anderen Worten bildet das Kontaktende im bestimmungsgemäßen Steckzustand mit dem ersten und zweiten Ende einen elektrischen mechanischen Schalter zum Schließen des Schutzstromkreises.

Über die Spannungsquelle wird im Steckzustand also ein Strom im Schutzstromkreis getrieben, welcher über die Strommesseinheit erkannt werden kann. Die Strommesseinheit liefert dann ein Erkennungssignal (Stecksignal). Über dieses oder dessen Weiterverarbeitung kann dann einem Benutzer des Testsystems und / oder dem Testsystem selbst signalisiert werden, dass der elektrische Kontakt zwischen Kontaktende und Bürsteneinheit bestimmungsgemäß hergestellt ist. So kann beispielsweise ein Anfahr- / Anlege- / Steck- / Schiebevorgang des Kontaktendes in Richtung auf die Bürsteneinheit hin beendet werden. Ein zu starkes Anpressen / Eindringen des Kontaktendes an / in die Bürste, ein zu starker Druck auf die Bürste usw. kann so verhindert werden.

Die Spannungsquelle ist insbesondere selbst potentialfrei in Bezug auf das Testsystem / Ersatzprüfmodul aufgebaut. Z.B. ist dieses galvanisch getrennt aufgebaut, sodass der Schutzstromkreis potentialfrei aus dem Ersatzprüfmodul / Testsystem mit Energie versorgt werden kann.

Die Strommesseinheit enthält insbesondere eine optische Anzeigeeinheit, welche das Fließen / Nichtfließen von Strom im Schutzstromkreis und damit den Steckzustand (oder nicht) anzeigt. Die optische Anzeigeeinheit ist insbesondere eine Lichtquelle, zum Beispiel eine LED, welche bei Stromfluss im Schutzstromkreis selbst von diesem durchströmt ist und dadurch Licht aussendet. Ein "Leuchten" der Anzeigeeinheit signalisiert somit einen erfolgreichen und ausreichenden Steckvorgang eines Kontaktendes an der Bürste.

Der Schutzstromkreis enthält insbesondere ein weiteres galvanisches Trennelement, um einen Stromfluss im Schutzstromkreis / das Stecksignal galvanisch getrennt an weitere das Stecksignal verarbeitende Systeme, z.B. das Testsystem, zu übermitteln. Das galvanische Trennelement ist insbesondere ein Optokoppler.

Über ein entsprechendes galvanisches Trennelement kann beispielsweise ein mechanischer Mikroschalter simuliert werden, welcher "mechanisch" eine korrekte Kontaktierung von Kontaktende und Bürsteneinheit erfassen könnte. Im Vergleich zu einem tatsächlichen Mikroschalter kann gemäß Schutzstromkreis diese Erfassung jedoch mechanisch schonender erfolgen.

Insbesondere ist jeder Kontakt des Ersatzprüfmoduls bzw. Testsystems mit einem eigenen Schutzstromkreis ausgerüstet. Eine Parallelschaltung ("logisches Oder") der Ausgangsseiten der galvanischen Trennelemente für mehrere Kontakte, z.B. die eines einzelnen Prüfmoduls eines Testsystems, sind hierbei denkbar. So kann zum Beispiel angezeigt werden, dass mindestens ein Kontakt / Bürste aus einer Gruppe von diesbezüglich parallel geschalteten Kontakten gesteckt / erfolgreich kontaktiert ist.

Insbesondere ist das zweite Ende des Schutzstromkreises ebenfalls an eine eigene, separate Bürsteneinheit / Bürste mit entsprechenden Bürstenhaaren angeschlossen. Mit anderen Worten wird zusätzlich zur Kontaktbürste des Ersatzprüfmoduls oder Testsystems (Teil des Kontakts) eine zweite Bürste benutzt, um das zweite Ende des Schutzstromkreises zu bilden. Somit kann die Steckerkennung des Kontaktendes insgesamt für das Kontaktende mechanisch besonders schonend durchgeführt werden, da dieses lediglich durch Bürsten schonend kontaktiert wird.

Insbesondere sind die Bürstenhaare der beiden an dem Schutzstromkreis angeschlossenen Bürsten nicht parallel, insbesondere quer zueinander angeordnet. Z.B. ist die Bürste / Bürstenhaare des Kontakts des Testsystems parallel zur Steckrichtung orientiert (z.B. als horizontale Kontaktbürste), die Bürste am zweiten Ende des Schutzstromkreises jedoch quer zur Steckrichtung (z.B. als vertikale Kontaktbürste) ausgerichtet.

In Bezug auf die Steckrichtung bildet die Bürste am zweiten Ende des Schutzstromkreises somit eine Art Schleifkontakt für das Kontaktende.

Weitere Merkmale, Wirkungen und Vorteile der Erfindung ergeben sich aus der nachfolgenden Beschreibung eines bevorzugten Ausführungsbeispiels der Erfindung sowie der beigefügten Figuren. Dabei zeigen, jeweils in einer schematischen Prinzipskizze:
- Figur 1: ein Blockschaltbild eines Testsystems beim Einsatz an einem Kabelbaum mit Steckverbindern,
- Figur 2a: eine Kohlefaserbürste, und
- Figur 2b: ein Paar solcher Bürsten zur Kontaktierung eines Kontaktendes einer Ader eines Kabelbaums, jeweils in einer perspektivischen Prinzipskizze,
- Figur 3: ein Ersatzprüfmodul mit vier Kontakten mit Bürstenpaaren gemäß Figur 2b in einer perspektivischen Prinzipskizze,
- Figur 4: den Kabelbaumtester aus Figur 1, bei dem ein Prüfmodul durch das Ersatzprüfmodul aus Figur 3 ersetzt wurde,
- Figur 5: ein Prinzipschaltbild des Ersatzprüfmoduls und eines Teils des Testsystems aus Figur 4,
- Figur 6: ein Ablaufdiagramm eines Kalibrierverfahrens für das Ersatzprüfmodul im Testsystem aus Figur 4,
- Figur 7: einen Schutzstromkreis zur Steckerkennung für Kontakte eines Prüfsystems.

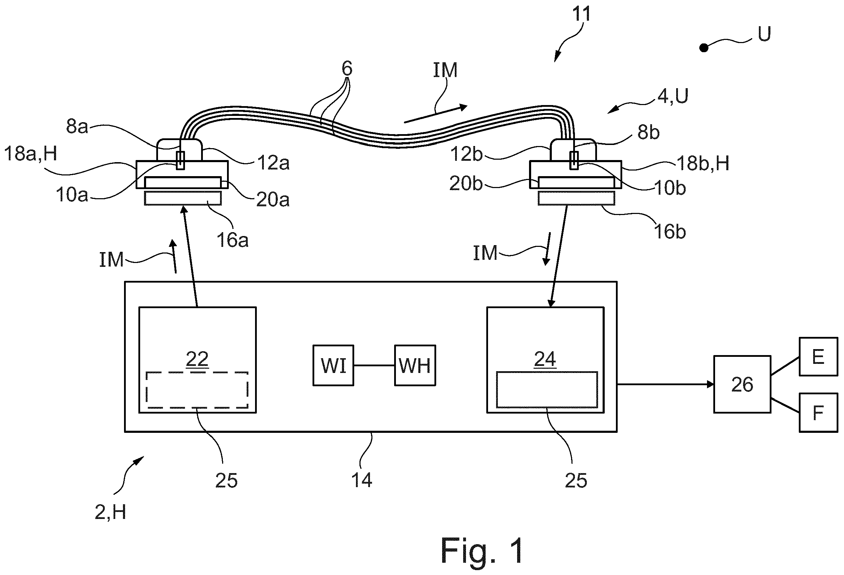

Figur 1 zeigt ein Testsystem 2 eines Herstellers H, das bei einem Unternehmen UN im Einsatz ist, um einen vom Unternehmen UN hergestellten Kabelbaum 4 zu testen. Der Kabelbaum 4 weist dabei eine Vielzahl, hier einhundert, Adern 6 auf, von denen in der Figur 1 nur drei Stück beispielhaft dargestellt sind. Alle drei Adern 6 sind jeweilige Einzeladern mit je zwei Kontaktenden 8a,b, hier abisolierte Litzenenden. Die Kontaktenden 8a,b weisen hier zusätzlich Kontaktelemente 10a,b auf, hier mechanisch empfindliche Crimpkontakte mit Strukturen im Sub-Millimeter-Bereich, die elektrisch und mechanisch an den Litzenenden angebracht sind, hier auf die Litzenenden aufgecrimpt sind.

Die Kontaktelemente 10a,b sind Teile von jeweiligen Steckverbindern 12a,b bzw. in deren Gehäusen eingehaust. Dadurch sind die Kontaktelement 10a,b und damit die Adern 6 mechanisch unempfindlich elektrisch kontaktierbar, nämlich durch Verbindung des Steckverbinders 12a,b mit einem jeweils passenden Gegen-Steckverbinder. Hierbei handelt es sich insbesondere um eine Aufnahme für den Steckverbinder 12a,b, der mit Prüfnadeln, also z.B. federbelasteten Goldnadeln zur elektrischen Kontaktierung der Steckkontakte. Dies ist in Figur 1 beispielhaft nur für eine der Adern 6 dargestellt bzw. angedeutet.

Das Testsystem 2 enthält einen eigentlichen Kabelbaumtester, kurz "Tester" 14, der zwei Schnittstellen 16a,b aufweist. Der Kabelbaum 4 ist zum Test zwischen den Schnittstellen 16a,b angeschlossen. Dazu ist an jeder der Schnittstellen 16a,b ein Prüfmodul 18a,b des Herstellers H angeschlossen. Dieses weist eine entsprechende Gegenschnittstelle 20a,b zur Verbindung mit den Schnittstellen 16a,b auf. Weiterhin enthalten die Prüfmodule 18a,b die auf den Kabelbaum 6 bzw. dessen Steckverbinder 12a,b zugeschnittenen, oben erläuterte Gegen-Steckverbinder. Durch Stecken der Steckverbinder 12a,b in die Prüfmodule 18a,b wird der Kabelbaum 4 bzw. dessen Adern 6 bzw. dessen Kontaktelemente 10a,b mechanisch unbedenklich und elektrisch mit dem Tester 14 verbunden und ein Kabelbaumtest kann in fachüblicher Weise durchgeführt werden, um insbesondere die Adern 6 auf deren elektrische Durchgängigkeit zwischen den Kontaktelementen 10a,b zu prüfen. Im Ergebnis sind also die Adern 6 elektrisch mit ihren Kontaktenden 8a,b zwischen die Schnittstellen 16a,b geschaltet.

Um den Test durchzuführen, weist der Tester 14 eine Quelle 22, hier eine Stromquelle auf. Im Testbetrieb erzeugt diese einen Messstrom IM, der über die Schnittstelle 16a und das Prüfmodul 18a zu der jeweils zu prüfenden Ader 6 hingeführt wird. Dazu enthält der Tester 14 nicht näher erläuterte Stromweichen zur Ansteuerung einer bestimmten Ader 6. Der Tester 14 enthält außerdem eine Senke 24, hier eine Stromsenke, in die der Messstrom IM, falls die Ader 6 durchgängig ist, einfließt. Dies geschieht über das zweite Prüfmodul 18b und die Schnittstelle 16b. Im Beispiel beträgt der Nennwert des Messstromes IM 20mA. Die Stromquelle 22 enthält dabei einen Innenwiderstand, der klein genug ist, um den Messstrom IM in Höhe des Nennwertes durch eine durchgängige Ader 6 zu treiben und dabei die Kontaktwiderstände und Leitungswiderstände im Stromweg (Leitungen, Steckverbinder, ...) zu überwinden. In der Senke 24 findet eine Strommessung des Istwertes WI des tatsächlich fließenden Messtromes IM statt. Hierzu enthält die Senke 24 eine Auswerteeinheit 25. Ist dieser größer oder gleich einem internen Grenzwert WH im Tester 14, hier 18mA, gibt der Tester ein Signal 26 mit Wert E ("Leitung erkannt") aus. Liegt der Istwert WI des Messstromes IM unter dem Grenzwert WH, wird das Signal 26 mit dem Wert F ("Leitung fehlt") ausgegeben.

Würde der Tester 14 in einer hier nicht dargestellten Variante über eine Spannungsquelle arbeiten, wäre die Quelle 22 eine Spannungsquelle, die eine Testspannung von z.B. 15V erzeugt, um den Messstrom IM in den Adern 6 zu erzeugen. Nicht die Senke 24, sondern die Quelle 22 enthielte dann die Auswerteeinheit 25 (hier gestrichelt angedeutet). In beiden Fällen arbeitet die Auswerteeinheit über einen Shuntwiderstand, der vom Messstrom IM durchflossen ist, um dessen Größe zu bestimmen. Eine Auswertung und Ausgabe des Signals 26 mit den Werten E (bei Spannungen ab 14V) oder F (bei Spannungen unter 14V) hin würde sinngemäß wie oben erläutert erfolgen.

Es gibt Fälle, in denen am Kabelbaum 6 ein hier beispielhaft gewähltes Kontaktende 8b mit einem Kontaktelement 10b bestückt ist, welches wie oben beschrieben mechanisch empfindlich ist, jedoch nicht durch das Gehäuse eines Steckverbindern 12b geschützt ist. Auch für einen derartigen Fall ergibt sich der Wunsch, den betreffenden Kabelbaum 4 mit dem Testsystem 2 testen zu können. Ein herkömmliches Prüfmodul 18b mit einem Gegenstück für einen Steckverbinder 12b scheidet dabei aus, da ein derartiger Steckverbinder 12b eben noch nicht existiert.

Daher findet, wie nachfolgend erläutert, die elektrische und mechanische Kontaktierung des Kontaktendes 8b bzw. Kontaktelements 10b über eine Bürsteneinheit 30 in einem Ersatzprüfmodul 42 eines Herstellers N statt, das vom Unternehmen UN anstelle des Prüfmoduls 18b mit der Schnittstelle 16b verbunden wird und damit Teil des ansonsten unveränderten Testsystems 2 wird.

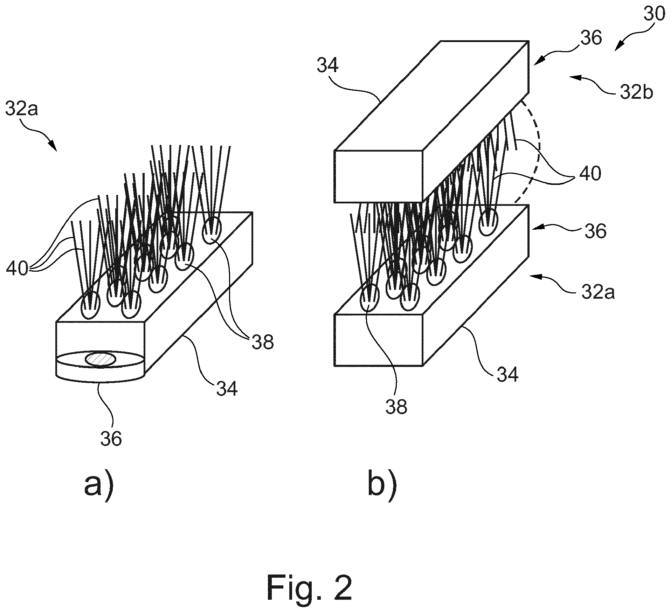

Figur 2a zeigt eine Bürste 32a, die einen Grundkörper 34 enthält, hier einen Kunststoffblock aus elektrisch leitendem Kunststoff, an dem ein elektrisches Anschlusselement 36, hier ein in den Grundkörper 34 eingegossenes Masseband mit aus dem Grundkörper 34 herausragender Anschlussöse, angebracht ist. Im Grundkörper 34 sind außerdem Halteelemente 38, hier elektrisch leitende Aderendhülsen, befestigt, hier vom Grundkörper 34 umgossen. In jedem der Halteelemente 38 ist ein Bündel elektrisch leitfähiger Bürstenhaare 40 gehalten, hier elektrisch leitende Kohlefasern. Somit ist die Bürste 32a in ihrer Gesamtheit, insbesondere bis in die Bürstenhaare 40 elektrisch leitend ausgebildet. Das Anschlusselement 36 bzw. die Anschlussöse dient dazu, die gesamte Bürste 32a bis hin zu den Bürstenhaaren 40 elektrisch zu kontaktieren. Figur 2a zeigt damit eine Bürste 32a in Form einer Kohlefaserbürste mit Anschlusspunkt (Anschlusselement 36 bzw. dessen Anschlussöse).

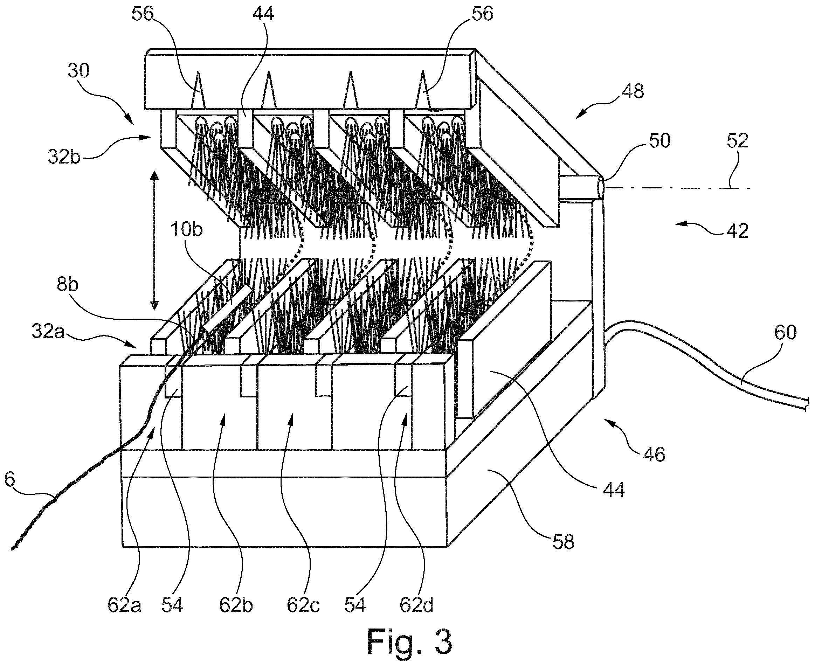

Figur 2b zeigt die Bürste 32a sowie eine baugleiche Bürste 32b, die zusammen die Bürsteneinheit 30 bilden. Im Gegensatz zu Figur 2a ist hier die entgegengesetzte Blickrichtung gewählt, so dass die Anschlusselemente 36 bzw. deren Anschlussösen hier nicht sichtbar auf der Rückseite der Bürsteneinheit 30 liegen. Eine elektrische Verbindung der beiden Bürsten 32a,b über die Anschlusselemente 36 ist in Figur 2b gestrichelt angedeutet. Diese macht das Bürstenpaar der Bürsten 32a,b zu einem einzigen elektrischen Kontakt 62a-d (siehe Figur 3). Figur 2b zeigt damit ein Kohlefaserbürstenpaar.

Figur 3 zeigt ein Ersatzprüfmodul 42 mit insgesamt vier Bürsteneinheiten 30. Stellvertretend für alle Bürsteneinheiten 30 wird nachfolgend nur die linke Bürsteneinheit 30, und wie mit deren Hilfe eine Ader 6 des Kabelbaums 4 kontaktiert wird, erläutert. In jeder der Bürsteneinheiten 30 sind die Bürsten 32a,b an ihren Anschlusselementen 36, hier durch eine elektrisch leitende flexible Bürstenverbindung, elektrisch verbunden, symbolisch angedeutet wieder durch eine gestrichelte Linie. Zwischen den Bürsteneinheiten 30 sind elektrisch nicht leitende bzw. elektrisch isolierende Trennelemente 44 angeordnet, um die Bürsteneinheiten 30 elektrisch gegeneinander zu isolieren. Das Ersatzprüfmodul 42 weist einen Boden 46 sowie einen Deckel 48 auf, die über ein Scharnier 50 um eine Schwenkachse 52 schwenkbar miteinander verbunden sind. Am Boden 46 sind die Bürsten 32a befestigt, am Deckel 48 die Bürsten 32b. Somit sind auch die Bürsten 32a,b je eines Bürstenpaares um die Schwenkachse 52 zueinander verschwenkbar.

Figur 3 zeigt den aufgeklappten Zustand zum Einlegen einer Ader 6 bzw. deren Kontaktende 8b mit Kontaktelement 10b. Jeder der Bürsteneinheiten 30 ist am Boden 46 eine Leitungs-Einführung 54 zugeordnet, durch die eine Ader 6 bzw. deren Kontaktende 8b mit Kontaktelement 10b in eine der Bürsteneinheiten 30 einführbar ist. Jeder Leitung-Einführung 54 ist am Deckel 48 eine Leitungs-Fixierung 56 zugeordnet, um im in Figur 3 nicht gezeigten geschlossenen Zustand die Ader 6 zwischen sich und der Leitungs- Einführung 54 mechanisch zu fixieren.

Das Ersatzprüfmodul 42 weist außerdem einen Aufnahmeraum 58, hier eine Box für Elektronik (z.B. Messelektronik 76, Steuereinheit 78 usw. siehe unten), auf. An der Rückseite des Ersatzprüfmoduls 42 befindet sich hier nicht sichtbar eine Gegenschnittstelle 20b (oder 20a, falls Anschluss an anderer Schnittstelle 16a) zur Verbindung mit einer Schnittstelle 16b des Testers 14. Die Gegenschnittstellen 20a,b sind die selben, die Bezeichnung "a,b" ergibt sich hier nur durch den Anschluss an die jeweilige Schnittstelle 16a oder 16b. Figur 3 zeigt lediglich symbolisch eine Kabelverbindung 60, die von der Schnittstelle 16b weiter zum Tester 14 führt.

Mit den vier Bürsteneinheiten 30 zwischen den Trennelementen 44 weist das Ersatzprüfmodul 42 insgesamt vier Kontakte 62 a-d zur Kontaktierung von insgesamt vier Adern 6 des Kabelbaumes 4 bzw. von deren Kontaktenden 8a,b mit Kontaktelementen 10a,b auf. Jede der Bürsteneinheiten 30 ist Bestandteil je eines Kontaktes 62a-d. Die Kontaktierung geschieht wie folgt:
Bei angehobenem Deckel 48 (wie in Fig. 3 dargestellt) wird die Ader 6 in die Leitungs-Einführung 54 eingelegt, so dass das Kontaktende 8b mit dem mechanisch empfindlichen Kontaktelement 10b auf den Bürstenhaaren 40 der Bürste 32a zu liegen kommt, wie in Figur 3 dargestellt. So wird mit bis zu vier Adern 6 Verfahren. Anschließend wird der Deckel 48 in Richtung des dargestellten Doppelpfeiles abgesenkt. Dadurch senken sich auch die Bürstenhaare 40 der Bürsten 32b ab, sodass schlussendlich das Kontaktende 8a, hier mit dem Kontaktelement 10a, mechanisch schonend zwischen den Bürstenhaaren 40 aufgenommen und dabei über diese elektrisch kontaktiert ist. Durch die Leitungs-Fixierung 56 wird dabei die Ader 6 zwischen sich und der Leitungs-Einführung 54 mechanisch fixiert, um sicher im Ersatzprüfmodul 42 gehalten zu sein.

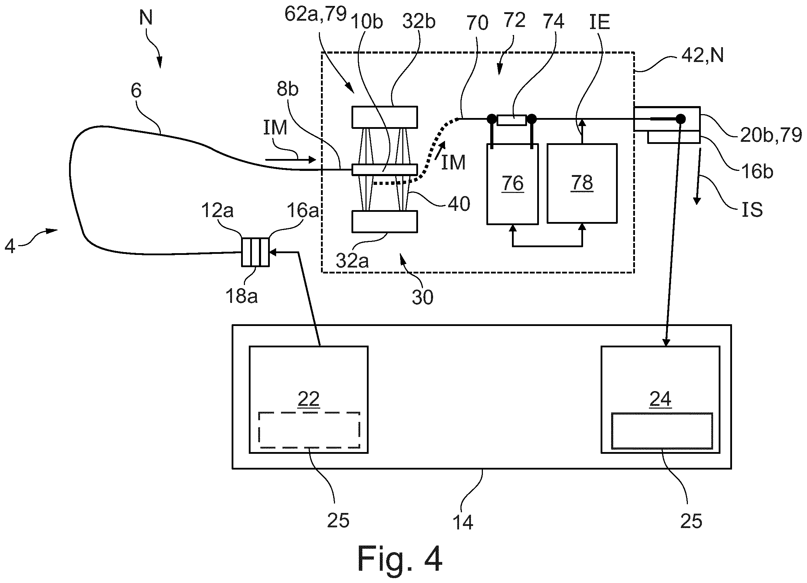

Figur 4 zeigt im Überblick den gesamten Testaufbau des Testsystems 2 unter Verwendung des Ersatzprüfmoduls 42. Wie in Figur 1 ist an der Schnittstelle 16a, die auf Seiten der Quelle 22 des Testers 14 liegt, ein hier nur schematisch angedeutetes Prüfmodul 18a befestigt, denn der Kabelbaum 4 weist an diesem Ende einen Steckverbinder 12a auf, mit dem der Kabelbaum 4 bzw. dessen Adern 6 einschließlich Kontaktenden 8a mit Kontaktelementen 10a in Steckverbindergehäusen in herkömmlicher Weise am Tester 14 bzw. dessen Schnittstelle 16a angeschlossen sind. Das andere Ende des Kabelbaums 4 bzw. dessen Adern 6 weisen jedoch wie oben beschrieben Kontaktenden 8b mit mechanisch empfindlichen Kontaktelementen 10b auf (der Übersichtlichkeit halber wieder nur eines dargestellt), welche nicht in Steckverbindergehäusen geschützt sind und welche daher mechanisch schonend elektrisch mit den Kontakten, hier dem Kontakt 62a, des Ersatzprüfmoduls 42 kontaktiert sind. Hierzu ist das Kontaktenden 8b mit Kontaktelement 10b der Ader 6 in der hier nur symbolisch angedeuteten Bürsteneinheit 30 des Kontakts 62a des Ersatzprüfmoduls 42 aufgenommen und so mechanisch schonend elektrisch kontaktiert. Die sich ergebende elektrische Verbindung, die sich über die Anschlusselemente 36 ergibt, ist gepunktet angedeutet.

Im Gesamtaufbau ist das Prüfmodul 18b aus Figur 1 daher durch das Ersatzprüfmodul 42 des Herstellers N ersetzt. Die Gegenschnittstelle 20b des Ersatzprüfmoduls 42 ist mit der Schnittstelle 16b des Testers 14 verbunden. Somit wird hier wie in Fig. 1 der entsprechende Messkreis zwischen den Schnittstellen 16a,b über den Kabelbaum 4 bzw. die aktuell zu testende Ader 6 geschlossen und kann prinzipiell wie in Figur eins vom Tester 14 getestet werden. Problematisch dabei ist jedoch, dass der Übergangswiderstand zwischen Kontaktelement 10b und den Bürstenhaaren 40 üblicherweise größer ist, als wenn die Verbindung wie in Fig. 1 in herkömmlicher Weise mit Hilfe von Steckverbindern 12b erfolgen würde. Das Ersatzprüfmodul 42 ist daher wie folgt ausgerüstet:
Eine elektrische Hauptleitung 70 verbindet den Kontakt 62a mit der Gegenschnittstelle 20b. Im Betrieb des Testers 14 wird diese Hauptleitung 70 - im Prinzip wie in Figur 1 - vom Messstrom IM in Richtung von der Quelle 22 zur Senke 24 durchflossen, was in Figur 4 durch Pfeile angedeutet ist. Im Ersatzprüfmodul 42 liegt der Gutwert WG vor, der in Bezug auf das Testsystem 14 gilt, zu dessen Ermittlung siehe unten. Wie oben erläutert, wird der Tester 14 die Ader 6 als durchgängig erkennen und ein Signal E ausgeben, wenn der Wert des Messstromes IM dem Gutwert WG oder höher entspricht, ansonsten wird er die Ader 6 gegebenenfalls (dies ist wegen mangelnder Kenntnisse über den Tester 14 ggf. nicht bekannt) als nicht durchgängig detektieren und das Signal F ausgeben.

Weiterhin liegt im Ersatzprüfmodul 42 ein Schwellwert WS vor. In diesem Schwellwert WS ist in Kenntnis der Bürstenanordnung 30 die dem Hersteller N bekannte Tatsache berücksichtigt, dass der Übergangswiderstand zwischen Kontaktende 8b bzw. Kontaktelement 10b und Bürsten 32a,b eventuell größer ist als bei der Kontaktierung der Kontaktenden 8b / Kontaktelemente 10b durch ein übliches Prüfmodul 18b des Herstellers H. Dem Hersteller N des Ersatzprüfmoduls 42 ist daher bekannt, dass in diesem Fall der Istwert Wl des Messstromes IM unterhalb des Gutwertes WG liegen kann, obwohl die Ader 6 durchgängig ist und am Tester das Signal E auszugeben ist. Im Ersatzprüfmodul 42 ist es daher bekannt, dass auch bei diesem Istwert WI des Messstromes IM der Tester 14 das Signal E ausgeben sollte. Erst wenn im Ersatzprüfmodul 42 ein Istwert WI detektiert wird, der unterhalb des Schwellwertes WS liegt, dann ist bekannt, dass der so weit verminderte Messstrom IM nicht mehr vom veränderten Kontaktwiderstand an den Bürsten 32a,b sondern tatsächlich von einem Defekt in der Ader 6 herrührt. In diesem Fall soll der Tester 14 unbeeinflusst bleiben, also wohl tatsächlich das faktisch zutreffende Signal F ausgeben.

Aus diesem Grund beinhaltet das Ersatzprüfmodul 42 in der Hauptleitung 70 ein Messmodul 72 zur Strommessung, d.h. zur Messung des Istwertes WI des aktuell in der Hauptleitung 70 fließenden Messstromes IM, der von dem Testsystem 2 erzeugt ist. Das Messmodul 72 ist hier ein in die Hauptleitung 70 eingeschalteter Shuntwiderstand 74 mit einer zugehörigen Messelektronik 76. Die Messelektronik 76 ist mit einer Steuereinheit 78 des Ersatzprüfmoduls 42 verbunden, im Beispiel über einen durch einen Doppelpfeil angedeuteten Bus. Die Steuereinheit 78 erzeugt - entsprechend der oben genannten Bedingungen, wenn nämlich der Istwert WI über dem Schwellwert WS liegt - einen Ergänzungsstrom IE, der dem Messstrom IM in der Hauptleitung 70 zugespeist wird. Die Summe des Messstromes IM und des Ergänzungsstromes IE, der Summenstrom IS, der dann über die Schnittstelle 16b zur Senke 24 des Testers 14 geleitet wird, ist so gewählt, dass diese dann dem Schwellwert WS entspricht, weshalb der Tester 14 das zutreffende Signal E ausgibt.

Im Ersatzprüfmodul ist daher ein Korrekturende 79 definiert: Hierbei handelt es sich vorliegend um die Gegenschnittstelle 20b, da diese der Schnittstelle 16b zugewandt ist, die zur Auswerteeinheit 25 in der Senke 24 führt.

Vorliegend wird also der Ergänzungsstrom IE an der Gegenschnittstelle 20b als Korrekturende 79 aus der Hauptleitung 70 - zusätzlich zum Messstrom IM - als Summenstrom IS ausgegeben.

Würde - wie in Figur 1 angedeutet - der Tester 14 mit einer Spannungsquelle als Quelle 22 arbeiten, wäre das Korrekturende 79 durch den Kontakt 62a gebildet, da dieser derjenigen Schnittstelle 16a des Testsystems 2 zugewandt wäre, die zur Auswerteeinheit 25, nun in der Quelle 22, führt. Der Ergänzungsstrom IE würde dann aus der Hauptleitung 70 abgeleitet, also aus der Hauptleitung 70 abgezogen. Der Messstrom IM fließt jedoch nach wie vor in der Hauptleitung 70 auch weiter zur Gegenschnittstelle 20b. Am Korrekturende 79 (nun der Kontakt 62a) würde dann der Summenstrom IS aus Messstrom IM und Ergänzungsstrom IE in das Ersatzprüfmodul 42 bzw. dessen Hauptleitung 70 eingezogen.

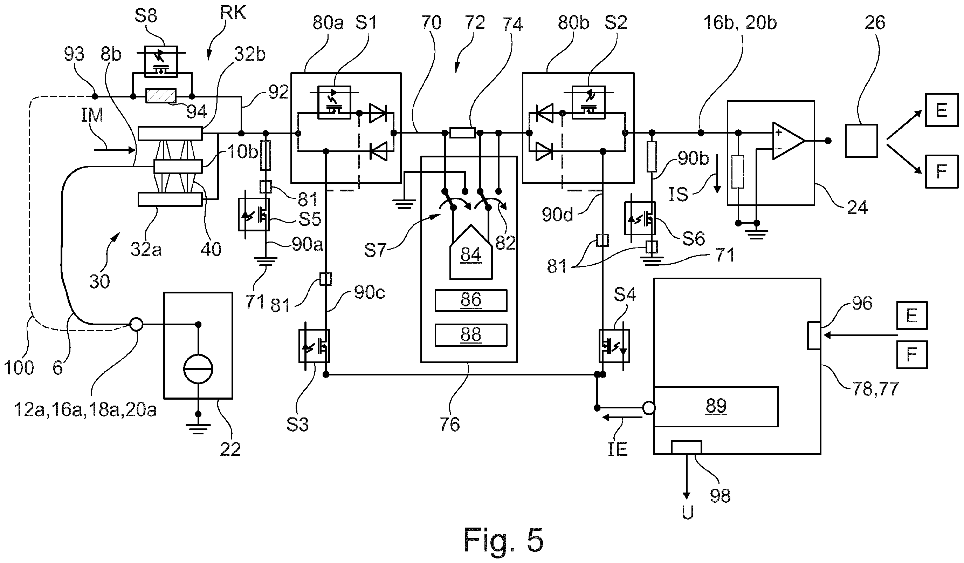

Figur 5 zeigt einen Teil der Anordnung aus Figur 4 in einem Prinzipschaltbild, nämlich insbesondere den Weg des Messstromes IM von der Quelle 22 zur Senke 24, sowie einen detaillierteren Aufbau des Ersatzprüfmoduls 42. Die aktuell gewählte Ader 6 des Kabelbaums 4 ist wieder die aktuell zu testende Ader 6.

In der Hauptleitung 70 sind beiderseits des Messmoduls 72 bzw. des Shuntwiderstandes 74 zwei Stromweichen 80a,b angeordnet, die zwei antiparallele Diodenpfade enthalten, wobei in einem der Diodenpfade jeweils ein Schaltelement S1,2 enthalten ist. Durch Schließen des Schaltelement S1 und Öffnen des Schaltelement S2 ist ein Stromfluss in Figur 5 von links nach rechts möglich. Durch Öffnen des Schaltelement S1 und Schließen des Schaltelement S2 ist ein Stromfluss in die Gegenrichtung möglich. Durch ein Doppel-Schaltelement S7 ist das Messmodul 72 außerdem von der in Figur 5 dargestellten Strommessung (Strom-Messbetrieb, Strommodus) in Richtung des Pfeils 82 auf eine Spannungsmessung gegen Masse (Spannungs-Messbetrieb, Spannungsmodus) an der Hauptleitung 70 umschaltbar. Zur Durchführung der entsprechenden Messungen enthält das Messmodul 72 einen Analog Digitalumsetzer 84, ein Register 86 sowie einen I2C-Bus 88 ("I-Quadrat-C-Bus"). Das Messmodul 72 ist somit dazu eingerichtet, wahlweise (je nach Stellung des Schalters S7) eine Strommessung oder eine Spannungsmessung ausführen zu können.

Die Steuereinheit 78 enthält eine gesteuerte Stromquelle 89 zur Ausgabe des Ergänzungsstromes IE, sowie - ohne diese näher zu bezeichnen - unter anderem eine Steuer- und Recheneinheit in Form eines Mikrocontrollers oder FPGA (Field Programmable Gate Array), eine Einheit zur Fehlerberechnung, einen Speicher zum Ablegen verschiedener Betriebsparameter, insbesondere des Gutwertes WG, Schwellwertes WS usw., einen Digital-Analogumsetzer sowie eine entsprechende Einheit zur Steuerung aller Schalter S1 bis S8, sowie einen I2C-Bus zur Kommunikation mit Gegenstellen, insbesondere dem I2C-Bus 88 der Messelektronik 76. Weiterhin enthält die Steuereinheit 78 eine Eingabeschnittstelle 96, um das vom Tester 14 erzeugte Signal 26 zu empfangen und so in der Steuereinheit 78 auswerten zu können. Die Steuereinheit 78 stellt damit also eine Stromquelle 77 für den Ergänzungsstrom IE dar.

Durch Schließen des Schalters S4 und Öffnen des Schalters S3 kann der Ergänzungsstrom IE (aus einer Stromquelle des Ersatzprüfmoduls 42) einem in Figur 5 von links nach rechts fließendem Messstrom IM in der Stromweiche 80b aufaddiert werden, durch Öffnen des Schalters S4 und Schließen des Schalters S3 kann der Ergänzungsstrom IE einem in Figur 5 von rechts nach links fließendem Messstrom in der Stromweiche 80a aufaddiert werden. Dabei fließt über den Shuntwiderstand 74 stets nur der Messstrom IM; nicht jedoch der Ergänzungsstrom IE und damit auch nicht der Summenstrom IS. Alternativ kann daher wie folgt vorgegangen werden: Durch Schließen des Schalters S3 und Öffnen des Schalters S4 kann der Ergänzungsstrom IE (aus einer Stromquelle des Ersatzprüfmoduls 42) einem in Figur 5 von links nach rechts fließendem Messstrom IM in der Stromweiche 80a aufaddiert werden, durch Öffnen des Schalters S3 und Schließen des Schalters S4 kann der Ergänzungsstrom IE einem in Figur 5 von rechts nach links fließendem Messstrom in der Stromweiche 80b aufaddiert werden. Dabei fließt über den Shuntwiderstand 74 dann neben dem Messstrom IM auch der Ergänzungsstrom IE und damit auch der Summenstrom IS. Somit kann der Summenstrom dort gemessen und ausgewertet werden. Die Schalter S3, S4 sind daher in Stichleitungen 90c,d enthalten, die der Zuleitung von Ergänzungsstrom IE in die Hauptleitung 70 dienen. Dies gilt für eine Auswertung in der Stromsenke des Testers 14.

Von der Hauptleitung 70 zweigen außerdem zwei Stichleitungen 90a,b ab, hier vom Messmodul 72 bzw. dem Shuntwiderstand 74 aus gesehen, jeweils jenseits der Stromweichen 80a,b. Die Stichleitungen 90a,b führen über Schalter S5,6 jeweils nach Masse und dienen durch Schließen des jeweiligen Schalters S5, S6 der Ableitung eines Ergänzungsstromes IE aus der Hauptleitung 70 jeweils nach Masse bzw. der wahlweisen Erdung des betreffenden Punktes der Hauptleitung 70. Die Masse stellt also hier jeweils eine Stromsenke 71 des Ersatzprüfmoduls 42 für den Ergänzungsstrom IE dar. Die Schalter S5, S6 in den Stichleitungen 90a,b werden ebenfalls über die Steuereinheit 78 angesteuert, um in Verbindung mit den nicht näher erläuterten Widerständen in den Stichleitungen 90a,b einen Ergänzungsstrom IE gewünschter Größe einzustellen. Dies gilt für eine Auswertung in der Stromquelle / Spannungsquelle des Testers 14. Zur Kontrolle des jeweils aktuell erzeugten Ergänzungsstromes IE sind hier nur symbolisch angedeutete Messeinheiten 81 vorgesehen.

Außerdem zweigt von der Hauptleitung 70 eine die Bürsteneinheit 30 überbrückende Kalibrierleitung 92 ab, die an einem Kalibrierkontakt 93 endet. Die Kalibrierleitung 92 enthält einen veränderbaren, hier schaltbaren, Kalibrierwiderstand RK. Die Veränderbarkeit ist hier dadurch realisiert, dass ein Festwiderstand 94 von hier 10 Ohm durch einen Schalter S8 überbrückbar ist.

Die Schalter S1 bis S8 sind hier FotoMoS-Halbleiterschalter mit einem On-widerstand von maximal 90 mOhm.

Im Betrieb des Ersatzprüfmoduls 42 sind die Schalter S1 und S2 normalerweise geschlossen, d.h. die Hauptleitung 70 ist dort jeweils und somit in beide Richtungen (in Fig. 5 von links nach rechts und umgekehrt) leitend. Erst durch das Öffnen von S1 (Strom von rechts nach links) oder S2 (Strom von links nach rechts) wird eine einzige Stromrichtung vorgegeben, in der der Messstrom IM fließen kann. Die Schalter S3 und S4 sowie S5 und S6 sind normalerweise offen, das heißt diese Schalter müssen wahlweise zum Einbringen / Abzweigen des Ergänzungsstroms IE in die / aus der Hauptleitung 70 in der gewünschten Stromrichtung (Schließen von S3: Zuspeisen von Strom nach links, Schließen von S4: Zuspeisen von Strom nach rechts) geschlossen werden.

Die Stichleitungen 90c,d können alternativ auch an den jeweils anderen Leitungen in den Stromweichen 80a,b angeschlossen sein. Die Schalter S3, S4, sind dann jeweils gleich zur obigen Beschreibung zu bedienen. Die grundlegende Einspeiserichtung in der Hauptleitung 70 bleibt jedoch gleich. In dieser Alternative misst jedoch der Shuntwiderstand 74 nach Schließen der Schaltern S3, S4 jeweils nicht nur den Messsstrom IM, sondern die Summe aus Messstrom IM und Ergänzungsstrom IE. So kann z.B. auf die Messeinheiten 81 verzichtet werden. Entsprechendes gilt um übrigen auch für das Abführen von Ergänzungssstrom IE aus der Hauptleitung 70 wahlweise über die Stichleitungen 90a,b. Auch hier kann so abgeleitet werden, dass der Summenstrom IS oder nur der Messstrom IM jeweils über den Shuntwiderstand 74 geführt wird. Durch Führen des Ergänzungsstromes IE über den Shunt 74 kann also dessen Regelung bzw. eine Regelung des Summenstromes IS implementiert werden.

Bei einem Test der Ader 6, welcher vom Tester 14 mittels Bestromung mit Messstrom IM durchgeführt wird, wird die Messelektronik 76 in einen "Strommodus" geschaltet (S7 in der Stellung wie in Fig. 5). In der gezeigten Konstellation (Strom-Quelle 22 links / Senke 24 rechts, also Messstrom IM von links nach rechts) wird der Messstrom IM im Shunt-Widerstand 74 gemessen. Dieser Strom entspricht dabei exakt dem von der Stromquelle 22 gelieferten Strom. Im Falle einer durchgängigen Ader 6 liegt der Istwert WI des Messstromes IM jedenfalls über dem Schwellwert WS. Je nachdem, ob der Kontaktwiderstand der Bürsteneinheit 30 die Quelle 22 dabei so belastet, dass der Messstrom IM unterhalb des vom Tester 14 erwarteten Gutwertes WG liegt, wird daher ein Ergänzungsstrom IE über den Schalter S4 der Hauptleitung 70 in der Stromweiche 80b additiv zugeführt oder nicht. So wird sichergestellt, dass an der Senke 24 stets ein Summenstrom IS ankommt, der genau (Ergänzungswert WE des Ergänzungsstromes IE = Gutwert WG - Istwert Wl) - oder in einer alternativen Ausführungsform mindestens (Ergänzungswert WE des Ergänzungsstromes IE = Gutwert WG - Schwellwert WS) - dem Gutwert WG entspricht. Der Tester 14 erzeugt damit richtigerweise das Signal E.

Liegt der gemessene Istwert WI unterhalb des Schwellwertes WS, da die Ader 6 fehlerhaft ist, wird kein Ergänzungsstrom IE erzeugt. Auch der Summenstrom IS an der Senke 24 liegt damit unterhalb des Gutwertes WG, weshalb der Tester 14 selbst (also unbeeinflusst durch einen Ergänzungsstrom IE) über das Signal 26 entscheidet, wohl richtigerweise das Signal F ausgibt.

Dabei wird stets eine ordnungsgemäße Kontaktierung der Ader 6 bzw. des Kontaktelements 10b in der Bürsteneinheit 30 vorausgesetzt, d.h. dass hier elektrischer Kontakt besteht und der Übergangswiderstand einen für das Ersatzprüfmodul 42 bestimmungsgemäßen Maximalwert von zum Beispiel 10 Ohm nicht übersteigt.

Bei einer in Figur 5 nicht dargestellten Variante wären im Testsystem 14 Quelle 22 und Senke 24 vertauscht. Im Gegensatz zu oben würde dann anstelle des Schalters S2 der Schalter S1 geöffnet, so dass ein Stromfluss in der Hauptleitung 70 von rechts nach links möglich ist. Strommessung und Auswertung würden identisch zu oben erfolgen, lediglich mit dem Unterschied, dass im Falle der Zuspeisung des Ergänzungsstromes IE nicht der Schalter S4 sondern der Schalter S3 geschlossen würde und die Zuspeisung daher in der Stromweiche 80a erfolgen würde.

In beiden bisher genannten Fällen wird das Ersatzprüfmodul 42 jeweils in einem Aktivprüfmodus MA betrieben: Das bedeutet, dass eine entsprechende Ermittlung des Istwertes WI, ein Vergleich mit dem Schwellwert WS und eine eventuelle Zuspeisung eines Ergänzungsstromes IE durchgeführt wird.

Für den Fall, dass der Tester 14 mit einer Spannungs-Quelle 22 und einer Spannungsmessung, d.h. Auswerteeinheit 25 in der Quelle 22 oder der Senke 24 arbeitet (in Figur 5 ebenfalls nicht dargestellt), würde sich folgendes Vorgehen ergeben:
Hierbei kann sicher von der Annahme ausgegangen werden, dass die Spannungsquelle 22 in dem Sinne niederohmig ausgeführt ist, dass deren Innenwiderstand gegen Null geht und die Quelle 22 und die Senke 24 zumindest Schutzwiderstände (z.B. 50 bis 200 Ohm) in der Testleitung enthalten. Bei einer derartigen Konfiguration kann ebenfalls sicher angenommen werden, dass ein bestimmungsgemäßer Übergangswiderstand zwischen Kontaktelement 10b und Bürsteneinheit 30 von z.B. maximal 10 Ohm, sowie ein Einfluss der sonstigen Bauteile in der Hauptleitung 70 (z.B. Dioden der Stromweichen 80a,b und Shuntwiderstand 74) für die Spannungsmessung und -auswertung im Tester 14 nicht ins Gewicht fällt. Der Test des Kabelbaums 4 kann im Tester 14 also wie üblich (vgl. Figur 1) durchgeführt werden.

Der Schalter S7 kann z.B. zeitweise, zu einer entsprechenden Spannungsmessung in Richtung des Pfeils 82 umgeschaltet werden, so dass die Messelektronik 76 im "SpannungsModus" arbeitet. So kann auch innerhalb des Ersatzprüfmoduls 42 die Spannung auf der Hauptleitung 70 beobachtet werden. Die Schalter S1 und S2 werden wie bei der Strommessung oben entsprechend geschaltet, je nachdem, ob Quelle 22 und 24 wie in Fig. 5 dargestellt angeordnet oder zueinander vertauscht sind. Die Schalter S3 und S4, S5 und S6bleiben stets offen, da eine Zuspeisung / Ableitung eines Ergänzungsstroms IE nicht notwendig ist. Hierbei arbeitet das Ersatzprüfmodul 42 daher in einem Passivprüfmodus MP, da keinesfalls eine Zuspeisung / Ableitung von Ergänzungsstrom IE erfolgt.

Das Ersatzprüfmodul 42 kann außerdem in einem Meldemodus MM betrieben werden, indem es an einer Ausgabeschnittstelle 98, hier einer Anzeigeleuchte, durch eine Meldung U "Einsatz nicht sinnvoll / nicht möglich" signalisiert, dass in der gegebenen Konfiguration mit einem Tester 14 der Betrieb des Ersatzprüfmoduls 42 nicht sinnvoll ist.

Eine weitere Betriebsart des Ersatzprüfmoduls 42 ist ein Diagnosemodus MD. Grund hierfür ist, dass dem Hersteller N des Ersatzprüfmoduls die Daten des Testers 14 des Herstellers H unter Umständen nicht zugänglich sind, z.B. aufgrund von Know-How-Schutz, einer Konkurrenzsituation, usw. Insofern handelt es sich aus Sicht des Herstellers N des Ersatzprüfmoduls 42 beim Tester 14 und ggf. den Prüfmodulen 18a,b um ein "Fremdprüfsystem". Durch den Diagnosemodus MD lassen sich jedoch die für den Betrieb des Ersatzprüfmoduls 42 am Tester 14 notwendigen Informationen erlangen.

Hierzu wird als Vorbereitung für den Diagnosemodus MD zunächst die in Figur 5 dargestellte Ader 6 bzw. der Kabelbaum 4 entfernt bzw. zumindest der entsprechende Messkreis durch den Kabelbaum 4 unterbrochen. Stattdessen wird, wie in Figur 5 gestrichelt dargestellt, eine bekannt durchgängige Kalibrierleitung 100 zwischen die Schnittstelle 12a und den Kalibrierkontakt 93 geschaltet. Sodann wird im Diagnosemodus MD wie folgt vorgegangen:

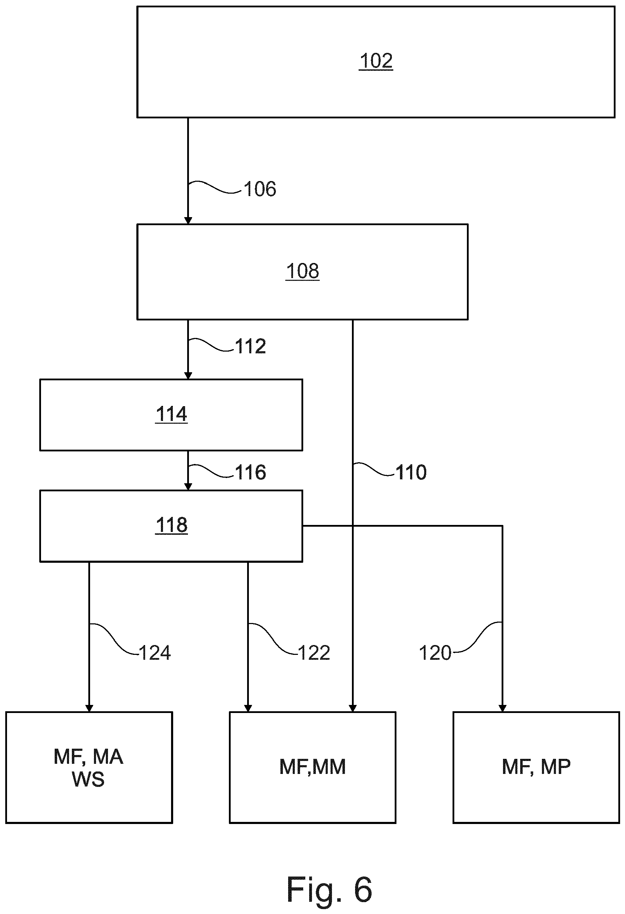

Figur 6 zeigt ein entsprechendes Ablaufdiagramm für den Diagnosemodus MD:
In einem Schritt 102 wird der Schalter S8 geschlossen und der Festwiderstand 94 überbrückt. Ein bekannt gute Kalibrierleitung 100 wird am Kalibrierkontakt 93 angeschlossen. Damit wird ein möglichst idealer Kurzschluss im Messkreis hergestellt und eine optimal leitende Ader 6 mit optimalen Kontakt zum Ersatzprüfmodul 42 simuliert. Die Messelektronik 76 wird in den Strommodus geschaltet. Sodann wird am Tester 14 ein Adertest gestartet.

Nach Start des Adertests wird - nach Überprüfung, ob der Tester die Meldung E ausgibt - der von Null verschiedene Istwert WI des Messstromes IM am Shuntwiderstand 74 ermittelt, wobei alle Schalter S3 - S6 geöffnet sind. Aus der gemessenen Stromrichtung des durch den Shuntwiderstand 74 fließenden Messstromes IM wird bestimmt, ob sich eine Strom- oder Spannungsquelle des Testers 14 auf Seiten des Kontaktes 62a-d oder der Gegenschnittstelle (20a,b) befindet.

Im Folgenden wird der Ablauf für einen im Ersatzprüfmodul 42 in der Figur 5 von links nach rechts fließenden Messstrom IM beschrieben. Ansonsten kehren sich die Verhältnisses entsprechend um. Sodann wird die in Stromrichtung des Messtromes IM dem Shuntwiderstand 74 nachgeschaltete Stichleitung 90a,b, hier also die Stichleitung 90b aktiviert, also der Schalter S6 geschlossen. Dadurch fließt Strom nicht nur über die Gegenschnittstelle 20b, sondern nun auch über die Stichleitung 90b aus der Hauptleitung 70 ab. Nun wird der Istwert WI des Messstromes IM erneut ermittelt. Hat sich dieser Istwert WI geändert, arbeitet das Testsystem 2 mit einer Spannungsquelle und gemäß Annahme einer quellenseitigen Auswerteeinheit 25. Das Korrekturende 79 ist der Kontakt 62a. Ist der Istwert WI dagegen gleich geblieben, arbeitet das Testsystem 2 mit einer Stromquelle und gemäß Annahme einer senkenseitigen Auswerteeinheit 25. Das Korrekturende ist die Gegenschnittstelle 20b. Fortgefahren wird so oder so mit Schritt 106 zu Schritt 108.

Im Schritt 108 erfolgt die Überprüfung, ob im Tester 14 nicht doch - entgegen der getroffenen Annahmen - eine Stromquelle mit quellenseitiger Auswertung vorliegt. Nun erfolgt eine Stromableitung in Stromrichtung des Messstromes IM gesehen vor dem Shuntwiderstand 74. Dies erfolgt im Beispiel an der Stichleitung 90a durch Schließen des Schalters S5. Dadurch fließt der gesamte Messtrom über die Stichleitung 90a zur Masse 71; die Senke 24 erhält keinen Strom. Wird nun im Tester 14 dennoch eine Leitung erkannt, findet eine quellenseitige Stromauswertung im Tester 14 statt. Meldet der Tester 14 also das Signal E, so wird geschlossen, das im Tester 14 eine Stromauswertung auf Seiten der Quelle 22 stattfindet. Kombiniert mit einer Stromquelle als Quelle 22 wäre nun ein Einsatz des Ersatzprüfmoduls 42 in der gegebenen Konfiguration nicht sinnvoll, weshalb über einen Schritt 110 als Folgemodus MF der Meldemodus MM gewählt wird. Kombiniert mit einer Spannungsquelle als Quelle 22 ist eine quellenseitige Auswertung im Tester 14 dagegen unkritisch. Über Schritt 112 wird dann mit Schritt 114 fortgefahren.

Im Schritt 114 wird zunächst der Kalibrierwiderstand RK unverändert auf Null gehalten und bei einem Adertest des Testers 14, der nun aufgrund unveränderter Umstände ebenfalls das Ergebnis E liefert, der Istwert WI des Messstromes IM erfasst und als Gutwert WG im Ersatzprüfmodul 42 gespeichert. Denn es wird davon ausgegangen, dass bei einem Messstrom IM in Höhe dieses Gutwertes WG der Tester 14 stets sicher das gewünschte Ergebnis E ausgibt.

Sodann wird über den Schritt 116 zum Schritt 118 fortgefahren. Im Schritt 118 wird nun der Kalibrierwiderstand RK erhöht bzw. aktiviert, hier durch Öffnen des Schalters S8. Nun wird erneut bei einem Adertest des Testers 14 der Istwert WI des Messstromes IM erfasst. Hier können nun drei Fälle auftreten.
- In einem ersten Fall entspricht der Istwert WI wieder dem Gutwert WG. Hieraus wird gefolgert, dass die Quelle 22 im Tester 14 kräftig genug ist, d.h. einen ausreichend niedrigen Innenwiderstand aufweist, um den Messstrom IM in voller Höhe des Gutwertes WG auch über den maximal anzunehmenden Kontaktwiderstand, der sich bei einer Kontaktierung einer Ader über die Bürsteneinheit 30 einstellen könnte, zu treiben. Denn dieser Widerstand wird durch den Kalibrierwiderstand simuliert. Die Zuspeisung / Abführung eines Ergänzungsstromes IE wird daher nicht benötigt, als Folgemodus MF wird über den Schritt 120 daher der Passivprüfmodus MF bestimmt. Alternativ könnte sicherheitshalber der Schritt 120 auch zum Aktivprüfmodus MA als Folgemodus MF führen.
- In einem zweiten Fall wird kein nennenswerter Messstrom IM als Istwert Wl gemessen, d.h. dieser liegt z.B. unter dem Sicherheitsmesslevel von 5mA. Der Tester 14 meldet außerdem das Signal F. Hieraus wird gefolgert, dass der eventuell mögliche Bürstenwiderstand (Übergangswiderstand von Ader 6 zur Bürsteneinheit 30) für den Tester 14 zu groß ist, das heißt dieser z.B. eine Quelle 22 mit zu großem Innenwiderstand aufweist. In diesem Fall ist der Betrieb des Ersatzprüfmoduls 42 nicht angezeigt, so dass über den Schritt 122 der Meldemodus MM als Folgemodus MF gewählt wird.
- Im dritten Fall meldet der Tester das Signal E oder F, der Istwert WI des Messstromes IM ist größer als null (zur Sicherheit z.B. wieder größer als 5mA), erreicht jedoch nicht den Gutwert WG. Die Quelle 22 ist also kräftig genug, um Messstrom IM bei intakter Ader 6 auch über den maximal anzunehmenden Kontaktwiderstand der Bürsteneinheit 30 zu treiben, jedoch mit Einbußen der Stromstärke (Istwert Wl). Die erreichte Stromstärke als Istwert Wl wird daher als Schwellwert WS intern im Ersatzprüfmodul 42 gespeichert, da bei Erreichen dieser Stromstärke vom Vorhandensein einer intakten Ader 6 unter Kenntnis des erhöhten Übergangswiderstandes an der Bürsteneinheit 30 ausgegangen werden kann. Um zu erreichen, dass der Tester 14 auch in diesem Fall Adern 6 sicher als intakt über die Meldung E anzeigt, wird im Schritt 124 als Folgemodus MF der Aktivprüfmodus MA bestimmt, d.h. im nachfolgenden Betrieb wird dem Tester 14 zusätzlich zum Messstrom IM der Ergänzungsstrom IE zugeführt / abgeleitet, falls die zu prüfende Ader 6 im Ersatzprüfmodul 42 als intakt detektiert wird (Istwert WI mindestens gleich dem Schwellwert WS). Der ermittelte bzw. gespeicherte Schwellwert WS wird dabei übernommen.

Im Falle des Aktivprüfmodus MA und Passivprüfmodus MP kann also nunmehr die Kalibrierleitung 100 entfernt, der Kabelbaum 4 kontaktiert werden und mit dem Test des Kabelbaums 4 unter Verwendung des Ersatzprüfmoduls 42 im entsprechenden Betriebsmodus (Aktivprüfmodus MA oder Passivprüfmodus MP) begonnen werden.

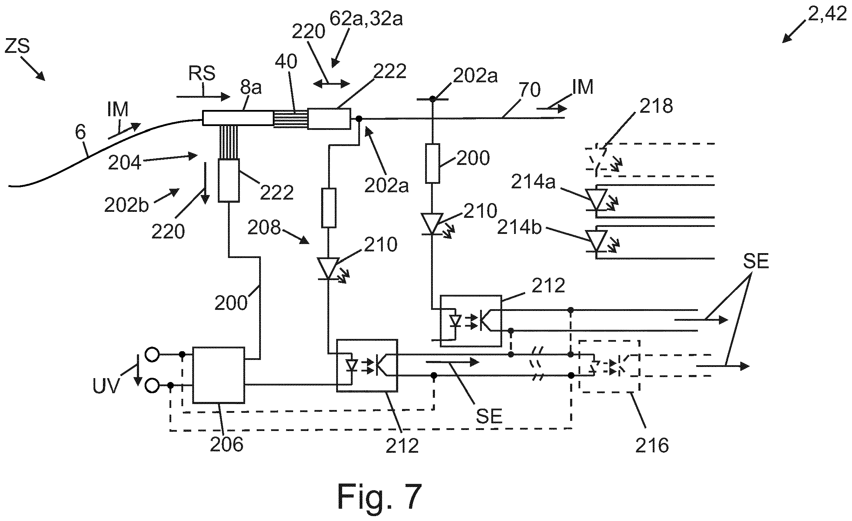

Figur 7 zeigt einen Ausschnitt aus einem Prüfsystem bzw. Testsystem 2, das nicht zwingend ein Ersatzprüfmodul 42 enthalten muss. Im Testsystem 2 ist das Kontaktende 8a einer Ader 6 an einem Kontakt 62a des Testsystems 2 anzuschließen, der über eine Hauptleitung 70 weiter in das Prüfsystem 2 geführt ist. Im Betrieb soll so der Messstrom IM fließen. Hierzu ist das Kontaktende 8a in den dargestellten Steckzustand ST zu bringen.

Der Kontakt 62a ist hier durch die Bürste 32a realisiert, bei der die Bürstenhaare 40 in einer Hülse 222, hier einer Aderendhülse, nach Art eines Pinsels gebündelt und gehalten sind. Im Steckzustand ZS liegt das Kontaktende 8a mit ausreichend Druck an der Bürste 32a bzw. den Spitzen der Bürstenhaare 40 an, dass ein ausreichender elektrischer Kontakt hergestellt ist. Der Druck ist jedoch klein genug, um die Bürstenhaare 40 nicht zu beschädigen bzw. dass das Kontaktende 8a nicht in die Bürstenhaare 40 eindringt.

Figur 7 zeigt den erfolgreich erreichten bestimmungsgemäßen Steckzustand ZS des Kontaktendes 8a an der Bürste 32a. Das Stecken bzw. Kontaktieren erfolgte dabei in einer Steckrichtung RS.

An dem Kontakt 62a ist ein Schutzstromkreis 200 angeschlossen. Dieser weist ein erstes Ende 202a und ein zweites Ende 202b auf. Zwischen den beiden Enden 202a,b ist der Stromkreis prinzipiell offen, hier jedoch durch das Kontaktende 8a geschlossen. Das erste Ende 202a ist elektrisch an dem Kontakt 62a bzw. die Bürste 32a angeschlossen. Am zweiten Ende 202b ist eine weitere Bürste 204 angeschlossen, welche wie folgt angeordnet ist:
Sie ist von der Bürste 32a ausreichend beabstandet, um mit dieser keinen elektrischen Kontakt zu bilden, so dass der Stromkreis 200 an dieser Stelle offen ist. Der Abstand und die Relativlage ist jedoch so beschaffen, dass bei Einlegen des Kontaktendes 8a im bestimmungsgemäßen Steckzustand ZS das Kontaktende 8a einen elektrischen Kontakt zwischen der Bürste 204 und der Bürste 32a bildet, wodurch der Schutzstromkreis 200 elektrisch geschlossen wird. Mit anderen Worten sind erstes 202a und zweites Ende 202b zusammen mit dem als bekannt vorausgesetzten Kontaktende 8a nach Art eines elektrischen Schalters konstruiert bzw. eingerichtet.

Der Schutzstromkreis 200 enthält in Reihenschaltung eine Spannungsquelle 206 sowie eine Strommesseinheit 208. Die Strommesseinheit 208 ist hier ausgeführt durch einen nicht näher bezeichneten Vorwiderstand und eine optische Anzeigeeinheit 210, hier in Form einer Leuchtdiode, z.B. grün. In den Schutzstromkreis 200 ist weiterhin in Reihe noch ein galvanisches Trennelement 212 geschaltet, hier ein Optokoppler. Dieser dient dazu, einen eventuell im Schutzstromkreis 200 fließenden Strom galvanisch getrennt in Form eines Erkennungssignals SE (hier nur symbolisch angedeutet) weiterzuleiten. Ein im Schutzstromkreis 200 fließender Strom repräsentiert somit den ordnungsgemäßen Steckzustand ZS, welcher durch Aufleuchten bzw. Aktivität der optischen Anzeigeeinheit 210, hier die aufleuchtende LED, angezeigt wird. Das Trennelement 212 simuliert daher einen jeweiligen Mikroschalter zur Steckerkennung einer der Adern 6 / Kontaktenden 8a,b,...

Ausführlich gezeigt in Figur 7 ist einer von hier fünf Kontaktkanälen mit je einem Kontakt 62a,b,... in einem Ersatzprüfmodul 42, in welchem also bis zu fünf Adern 6 mit ihren jeweiligen Kontaktenden 8a,b,... usw. aufgenommen werden können. Weitere Kontaktkanäle sind hier lediglich symbolisch angedeutet.

Die Spannungsquelle 206 enthält hier einen DC/DC Wandler, der galvanisch getrennt ist, so dass diese bzw. der Schutzstromkreis 200 potentialgetrennt durch eine Versorgungsspannung UV des Testsystems 2 versorgt werden kann.

Figur 7 zeigt weiterhin zwei von insgesamt fünf LEDs 214a,b,... Diese werden vom Testsystem 2 ein- /ausgeschaltet. Damit wird signalisiert, dass Adern 6 in das Ersatzprüfmodul 42 eingesteckt werden sollen. Das Testsystem 2 schaltet diese LEDs (zum Beispiel rot) wieder aus, wenn über das galvanische Trennelement 212 bzw. das entsprechende Erkennungssignal SE gemeldet wird, dass eine jeweilige Ader 6 in den betreffenden Kontakt 62a,b,... erfolgreich gesteckt wurde.

Zusammenfassend lässt sich sagen: Um galvanische Rückkopplungen zwischen den Adern 6 auszuschließen, wird jeder der hier fünf Kanäle bzw. dessen eigener Schutzstromkreis 200 über einen potentialgetrennten DC/DC-Wandler in Form der Spannungsquelle 206 mit Strom bzw. Spannung versorgt. Dabei ist die Schutzschaltung bzw. der Schutzstromkreis 200 so ausgelegt, dass er über die zum Beispiel 24V (UV) Spannungsversorgung des Testsystems 2 angeschlossen werden kann.

Wenn durch den Kontakt, also das Kontaktende 8a der Ader 6 die Verbindung zwischen der Kontaktbürste 32a (hier als horizontale Kontaktbürste) und der Kontaktbürste 204 (hier als vertikale Kontaktbürste) hergestellt wird, fließt ein Strom im Schutzstromkreis 200 über die optische Anzeigeeinheit 210, hier in Form der grünen LED, und die LED des galvanischen Trennelements 212 in Form des Optokopplers.

Mit der grünen LED (optische Anzeigeeinheit 210) wird angezeigt, dass der Aderkontakt / das Kontaktende 8a richtig gesteckt ist. Im Strompfad (Schutzstromkreis 200) der grünen LED (optische Anzeigeeinheit 210) befindet sich der Optokoppler in Form des galvanisches Trennelements 212. Dieser übernimmt die Funktion eines Mikroschalters, über den an das Testsystem 2 "gesteckte Ader" im Ersatzprüfmodul 42 / Kontakt 62a,b,... gemeldet wird. Hierzu dient das Erkennungssignal SE.

In einer alternativen, hier gestrichelt angedeuteten Variante sind die Fototransistoren der Optokoppler der galvanisches Trennelement 212 parallel geschaltet. Über ein weiteres galvanisches Trennelement 216, im Beispiel wieder ein Optokoppler bzw. dessen LED ist dieser an eine externe Spannungsquelle (Versorgung (UV) der Spannungsquelle 206) angeschlossen. Dieses galvanisches Trennelement 216 übernimmt ebenfalls die Funktion eines Mikroschalters, über den an das Testsystem 2 wiederum "gesteckte Adern" im Ersatzprüfmodul 42 gemeldet werden, hier jedoch sobald eine der Adern 6 gesteckt ist.

Anstelle von fünf LEDs 214a,b,... kann dann auch nur eine vorgesehen sein, um generell anzuzeigen, dass überhaupt Adern in das entsprechende Ersatzprüfmodul 42 gesteckt werden sollen. Das Testsystem 2 schaltet die LED(s) 214a,b,... wieder aus, wenn über das galvanisches Trennelement 216 gemeldet wird, dass Adern 6 in das Ersatzprüfmodul 42 gesteckt wurden. Eine optionale weitere LED 218, zum Beispiel Blau, wird vom Testsystem 2 für Serviceanforderungen genutzt.

Um die durch den Schutzstromkreis 200 etablierte Stecküberwachung für die Kontaktenden 8a,b,... auf verschiedene Kontaktenden verschiedener mechanischer Dimensionen anpassen zu können, sind insbesondere die Bürsten 32a, 204 entlang einer jeweiligen Verstellrichtung 220 verschiebbar und justierbar.

Ein eventueller Prüfstrom / Messstrom IM kann somit ungehindert durch die Ader 6, das Kontaktende 8a, die Bürste 32a und die Hauptleitung 70 fließen. Der im Schutzstromkreis 200 fließende Strom und der Messstrom IM beeinflussen sich gegenseitig nicht. Auch eine Potentialbeeinflussung erfolgt wegen der vollständigen galvanisches Trennung des Schutzstromkreises 200 nicht.

### Bezugszeichenliste

- 2: Testsystem
- 4: Kabelbaum
- 6: Ader
- 8a,b: Kontaktende
- 10a,b: Kontaktelement
- 12a,b: Steckverbinder
- 14: Tester
- 16a,b: Schnittstelle
- 18a,b: Prüfmodul
- 20a,b: Gegenschnittstelle
- 22: Quelle
- 24: Senke
- 25: Auswerteeinheit
- 26: Signal
- 30: Bürsteneinheit
- 32a,b: Bürste
- 34: Grundkörper
- 36: Anschlusselement
- 38: Halteelement
- 40: Bürstenhaar
- 42: Ersatzprüfmodul
- 44: Trennelement
- 46: Boden
- 48: Deckel
- 50: Scharnier
- 52: Schwenkachse
- 54: Leitungs-Einführung
- 56: Leitungs-Fixierung
- 58: Aufnahmeraum
- 60: Kabelverbindung
- 62a-d: Kontakt
- 70: Hauptleitung
- 71: Stromsenke
- 72: Messmodul
- 74: Shuntwiderstand
- 76: Messelektronik
- 77: Stromquelle
- 78: Steuereinheit
- 79: Korrekturende
- 80a,b: Stromweiche
- 81: Messeinheit
- 82: Pfeil
- 84: Analog Digital Umsetzer
- 86: Register
- 88: I2C-Bus
- 89: Stromquelle
- 90a,b: Stichleitung
- 92: Kalibrierleitung
- 93: Kalibrierkontakt
- 94: Festwiderstand
- 96: Eingabeschnittstelle
- 98: Ausgabe Schnittstelle
- 100: Kalibrierleitung
- 102-124: Schritt
- 200: Schutzstromkreis
- 202a,b: erstes, zweites Ende
- 204: Bürste
- 206: Spannungsquelle
- 208: Strommesseinheit
- 210: optische Anzeigeeinheit
- 212: galvanisches Trennelement
- 214a,b: LED (rot)
- 216: galvanisches Trennelement
- 218: LED (blau)
- 220: Verstellrichtung
- 222: Hülse

- H: Hersteller
- UN: Unternehmen
- N: Hersteller
- IM: Messstrom
- WG: Gutwert
- E: Meldung "Leitung erkannt"
- F: Meldung "Leitung fehlt"
- WH: Grenzwert
- WS: Schwellwert
- WI: Istwert
- IE: Ergänzungsstrom
- WE: Ergänzungswert
- IS: Summenstrom
- S1-8: Schaltelement
- RK: Kalibrierwiderstand
- MA: Aktivprüfmodus
- MP: Passiv Modus
- MM: Meldemodus
- MD: Diagnosemodus
- U: Meldung "nicht sinnvoll / nicht möglich"
- ZS: Steckzustand
- RS: Steckrichtung
- SE: Erkennungssignal
- UV: Versorgungsspannung

## Patentansprüche

1. Ersatzprüfmodul (42) für ein Testsystem (2), wobei das Testsystem (2) zwei Schnittstellen (16a,b) zum Anschluss eines jeweiligen Prüfmoduls (18a,b) aufweist und das Testsystem (2) dazu eingerichtet ist, einen zwischen den Schnittstellen (16a,b) angeschlossenen Kabelbaum (4) zumindest auf elektrische Durchgängigkeit (E,F) seiner Adern (6) zu testen, wozu die Adern (6) mit ihren Kontaktenden (8a,b) elektrisch zwischen die Schnittstellen (16a,b) geschaltet sind,
- mit einer Gegenschnittstelle (20a,b) zum Anschluss an eine der Schnittstellen (16a,b) des Testsystems (2),
- mit mindestens einem Kontakt (62a-d) zur elektrischen Kontaktierung eines jeweiligen Kontaktendes (8a,b) des Kabelbaums (4),
- mit einer die Gegenschnittstelle (20a,b) mit dem Kontakt (62a-d) verbindenden elektrischen Hauptleitung (70), die im Betrieb des Testsystems (2) von einem von diesem erzeugten Messstrom (IM) durchflossen ist,
- mit einem in Bezug auf das Testsystem (2) vorgebbaren Gutwert (WG) für den Messstrom (IM),
- mit einem in Bezug auf das Ersatzprüfmodul (42) vorgebbaren Schwellwert (WS) für den Messstrom (IM), der kleiner dem Gutwert (WG) ist,
- wobei das Ersatzprüfmodul (42) eine Steuereinheit (78) enthält, die dazu eingerichtet ist,
- das Ersatzprüfmodul (42) zumindest in einem Aktivprüfmodus (MA) zu betreiben, in dem:
- ein Istwert (WI) des von dem Testsystem (2) erzeugten, durch die Hauptleitung (70) fließenden Messstromes (IM) ermittelt wird, und
- für den Fall, dass der Istwert (WI) über dem Schwellwert (WS) liegt,
- an der Hauptleitung (70) ein Summenstrom (IS) am Kontakt (62a-d) oder der Gegenschnittstelle (20a,b) als Korrekturende (79a,b) des Ersatzprüfmoduls (42) eingezogen oder ausgegeben wird, der aus dem Messstrom (IM) und einem aus der oder in die Hauptleitung (70) zusätzlich abgeleiteten oder eingespeisten Ergänzungsstrom (IE) mit einem vorgebbaren Ergänzungswert (WE) zusammengesetzt ist, wobei der Ergänzungswert (WE) so dimensioniert ist, dass der Wert des aus dem Testsystem (2) bezogenen oder zum Testsystem (2) zurückgelieferten Summenstromes (IS) mindestens den Gutwert (WG) annimmt,
- wobei das Korrekturende (79a,b) derjenigen Schnittstelle (16a,b) des Testsystem (2) zugewandt ist, das zu einer Auswerteeinheit (25) des Testsystems (2) führt,
- ansonsten:
- an der Hauptleitung (70) der Messstrom (IM) unverändert am Ersatzprüfmodul (42) ausgegeben wird;
das Ersatzprüfmodul (42) ist **dadurch gekennzeichnet, dass** der Kontakt (62a-d) eine Bürsteneinheit (30) enthält, in der das jeweilige Kontaktende (8a,b) des Kabelbaums (4) aufnehmbar und elektrisch kontaktierbar ist, wobei die Bürsteneinheit (30) elektrisch leitfähige Bürstenhaare (40) zur mechanisch schonenden elektrischen Kontaktierung des Kontaktendes (8a,b) aufweist.

2. Ersatzprüfmodul (42) nach Anspruch eins,
**dadurch gekennzeichnet, dass**
der Ergänzungswert (WE) der Differenz von Gutwert (WG) und Schwellwert (WS) oder von Gutwert (WG) und Istwert (WI) entspricht.

3. Ersatzprüfmodul (42) nach einem der vorhergehenden Ansprüche,
**dadurch gekennzeichnet, dass**
die Steuereinheit (78) dazu eingerichtet ist,
- das Ersatzprüfmodul (42) in einem Passivprüfmodus (MP) zu betreiben, in dem der Messstrom (IM) mit seinem Istwert (WI) stets unverändert durch das Ersatzprüfmodul (42) durchgeleitet wird.

4. Ersatzprüfmodul (42) nach einem der vorhergehenden Ansprüche,
**dadurch gekennzeichnet, dass**
die Steuereinheit (78) dazu eingerichtet ist,
- das Ersatzprüfmodul (42) in einem Meldemodus (MM) zu betreiben, in dem das Ersatzprüfmodul (42) eine Meldung (U) ausgibt, die anzeigt, dass ein Einsatz des Ersatzprüfmoduls (42) mit dem Testsystem (2) nicht sinnvoll ist.

5. Ersatzprüfmodul (42) nach einem der vorhergehenden Ansprüche, gegebenenfalls in Verbindung mit einem der Ansprüche 3 bis 4,
**dadurch gekennzeichnet, dass**
die Steuereinheit (78) dazu eingerichtet ist,
- das Ersatzprüfmodul (42) in einem Diagnosemodus (MD) zu betreiben, in dem das Ersatzprüfmodul (42) Eigenschaften eines angeschlossenen Testsystems (2) ermittelt, und basierend auf diesen Eigenschaften ermittelt, ob im Ersatzprüfmodul (42) in Verbindung mit dem Testsystem der Aktivprüfmodus oder - falls vorhanden - der Passivprüfmodus oder -falls vorhanden - der Meldemodus als ein Folgemodus gewählt werden soll.

6. Ersatzprüfmodul (42) nach einem der vorhergehenden Ansprüche,
**dadurch gekennzeichnet, dass**
die Hauptleitung (70) ein Messmodul (72) zur Strommessung enthält.

7. Ersatzprüfmodul (42) nach Anspruch 6,
**dadurch gekennzeichnet, dass**
die Hauptleitung (70) beidseitig des Messmoduls (72) eine jeweilige Stromweiche (80a,b) enthält, die beide dazu eingerichtet sind, eine Stromrichtung in der Hauptleitung (70) vorzugeben.

8. Ersatzprüfmodul (42) nach einem der vorhergehenden Ansprüche,
**dadurch gekennzeichnet, dass**
von der Hauptleitung (70) wenigstens eine zu einer Stromquelle (77) oder Stromsenke (71) für den Ergänzungsstrom (IE) führende Stichleitung (90a,b) abzweigt, die zu einer wahlweisen Einspeisung und/oder Ableitung des Ergänzungsstromes (IE) in die und/oder aus der Hauptleitung (70) ausgebildet ist.

9. Ersatzprüfmodul (42) nach Anspruch 8,
**dadurch gekennzeichnet, dass**
wenigstens eine der Stichleitungen (90a,b) eine Messeinheit (81) für den dort fließenden Ergänzungsstrom (IE) enthält.

10. Ersatzprüfmodul (42) nach Anspruch 7 bis 9
**dadurch gekennzeichnet, dass**
wenigstens eine der Stichleitungen (90a,b) aus wenigstens einer der Stromweichen (80a,b) abgezweigt ist.

11. Ersatzprüfmodul (42) nach einem der vorhergehenden Ansprüche,
**dadurch gekennzeichnet, dass**
von der Hauptleitung (70) eine die Bürsteneinheit (30) überbrückende Kalibrierleitung (92) abzweigt, die an einem Kalibrierkontakt (93) endet.

12. Ersatzprüfmodul (42) nach Anspruch 11,
**dadurch gekennzeichnet, dass**
die Kalibrierleitung (92) einen umschaltbaren oder veränderbaren Kalibrierwiderstand (RK) enthält.

13. Ersatzprüfmodul (42) nach einem der vorhergehenden Ansprüche,
**dadurch gekennzeichnet, dass**
das Ersatzprüfmodul (42) eine Eingabeschnittstelle (96) aufweist, um eine Meldung vom Testsystem (2) zu empfangen, mindestens ob dieses eine aktuell getestete Ader (6) als durchgängig (E) oder nicht durchgängig (F) bewertet.

14. Verfahren zum Testen mindestens einer elektrischen Ader (6) eines Kabelbaums (4) mit Hilfe des Ersatzprüfmoduls (42) nach einem der vorhergehenden Ansprüche und des Testsystems (2), wobei die Ader (6) mindestens ein Kontaktende (8a,b) aufweist,
wobei das Verfahren folgende Schritte aufweist:
- das Ersatzprüfmodul (42) wird in elektrischer Reihenschaltung mit der Ader (6) zwischen die Schnittstellen (16a,b) geschaltet, wobei das Kontaktende (8a,b) in der Bürsteneinheit (30) aufgenommen und elektrisch kontaktiert wird,
- die Ader (6) wird mit Hilfe des Testsystems (2) auf elektrische Durchgängigkeit (E, F) geprüft.

15. Verfahren nach Anspruch 14 in Verbindung mit den Ansprüchen 5 und 11,
**dadurch gekennzeichnet, dass**
vor Beginn des Testens der Ader (6):
- das Ersatzprüfmodul (42) mit einer der Schnittstellen (16a,b) verbunden wird,
- der Kalibrierkontakt (93) über einen bekannt durchgängige Kalibrierleitung (100) mit der anderen Schnittstelle (16a,b) verbunden wird,
- das Ersatzprüfmodul (42) im Diagnosemodus (MD) und anschließend im dort ermittelten Folgemodus (MF) betrieben wird.

16. Verfahren nach Anspruch 15 in Verbindung mit den Ansprüchen 3, 4 und 12,
**dadurch gekennzeichnet, dass**
im Diagnosemodus (MD) vom Ersatzprüfmodul (42):
- a) ermittelt wird ob das Testsystem (2) mit einer Spannungs- oder Stromquelle arbeitet, und ob das Korrekturende (79) durch den Kontakt (62a-d) oder die Gegenschnittstelle (20a,b) gebildet ist,
- b) der Istwert (WI) des bei einem Kalbrierwiderstand (RK) von Null fließende Messstromes (IM) als Gutwert (WG) ermittelt wird, und
- bei einem vorgebbaren Kalibrierwiderstand (RK), der mindestens so groß wie der zu erwartende übliche Kontaktwiderstand in der Bürstenanordnung (30) ist, der Istwert (WI) des Messstromes (IM) ermittelt wird, und
- falls der Istwert (WI) unterhalb eines vorgebbaren Minimalwertes liegt, der Meldemodus (MM) als Folgemodus (MF) gewählt wird,
- falls der Istwert (WI) dem Gutwert (WG) entspricht, der Passivprüfmodus (MP) als Folgemodus (MF) gewählt wird,
- ansonsten der Istwert (WI) als Schwellwert (WS) verwendet wird und der Aktivprüfmodus (MA) als Folgemodus (MF) gewählt wird.

## Claims

1. A replacement test module (42) for a test system (2), wherein the test system (2) has two interfaces (16a,b) for connecting a respective test module (18a,b) and the test system (2) is arranged to test a cable harness (4) connected between the interfaces (16a,b) at least for electrical continuity (E,F) of its wires (6), wherefore the wires (6) are electrically connected with their contact ends (8a,b) between the interfaces (16a,b),
- having a counter-interface (20a,b) for connecting to one of the interfaces (16a,b) of the test system (2),
- having at least one contact (62a-d) for electrically contacting a respective contact end (8a,b) of the cable harness (4),
- having an electrical main line (70) connecting the counter-interface (20a,b) to the contact (62a-d), through which electrical main line a measurement current (IM) generated by the test system (2) flows during the operation of said test system,
- having a good value (WG) for the measurement current (IM), which can be specified with respect to the test system (2),
- having a threshold (WS) for the measurement current (IM), which can be specified with respect to the replacement test module (42) and which is less than the good value (WG),
- wherein the replacement test module (42) includes a control unit (78) which is arranged
- to operate the replacement test module (42) at least in an active test mode (MA) in which:
- an actual value (WI) of the measurement current (IM) generated by the test system (2), flowing through the main line (70) is determined, and
- in the event that the actual value (WI) is above the threshold (WS),
- on the main line (70) a sum current (IS) is drawn in or output at the contact (62a-d) or the counter-interface (20a,b) as the correction end (79a,b) of the replacement test module (42), which sum current is composed of the measurement current (IM) and a supplementary current (IE) which is additionally discharged from or fed into the main line (70) with a specifiable supplementary value (WE), wherein the supplementary value (WE) is dimensioned such that the value of the sum current (IS) drawn from the test system (2) or returned to the test system (2) at least assumes the good value (WG),
- wherein the correction end (79a,b) faces that interface (16a,b) of the test system (2), which leads to an evaluation unit (25) of the test system (2),
- otherwise:
- the measurement current (IM) is output unaltered at the replacement test module (42) on the main line (70);
the replacement test module (42) is **characterized in that** the contact (62a-d) includes a brush unit (30) in which the respective contact end (8a,b) of the cable harness (4) can be received and electrically contacted, wherein the brush unit (30) has electrically conductive bristles (40) for electrically contacting the contact end (8a,b) in a mechanically protective manner.

2. The replacement test module (42) according to Claim 1,
**characterized in that**
the supplementary value (WE) corresponds to the difference between the good value (WG) and the threshold (WS) or between the good value (WG) and the actual value (WI).

3. The replacement test module (42) according to any one of the preceding claims,
**characterized in that**
the control unit (78) is arranged
- to operate the replacement test module (42) in a passive test mode (MP) in which the measurement current (IM) with its actual value (WI) is constantly conducted unaltered through the replacement test module (42).

4. The replacement test module (42) according to any one of the preceding claims,
**characterized in that**
the control unit (78) is arranged
- to operate the replacement test module (42) in a reporting mode (MM) in which the replacement test module (42) outputs a message (U) which indicates that a deployment of the replacement test module (42) with the test system (2) does not make sense.

5. The replacement test module (42) according to any one of the preceding claims, possibly in conjunction with any one of Claims 3 to 4,
**characterized in that**
the control unit (78) is arranged
- to operate the replacement test module (42) in a diagnostic mode (MD) in which the replacement test module (42) determines properties of a connected test system (2) and, based on these properties, determines whether the active test mode or - if present - the passive test mode or - if present - the reporting mode is to be selected as a follow-up mode in the replacement test module (42) in conjunction with the test system.

6. The replacement test module (42) according to any one of the preceding claims,
**characterized in that**
the main line (70) includes a measuring module (72) for measuring current.

7. The replacement test module (42) according to Claim 6,
**characterized in that**
the main line (70) includes a respective current divider (80a,b) on both sides of the measuring module (72), both of which current dividers are arranged to specify a current direction in the main line (70).

8. The replacement test module (42) according to any one of the preceding claims,
**characterized in that**
at least one stub (90a,b) leading to a current source (77) or current sink (71) for the supplementary current (IE) branches off from the main line (70), which is configured for a selective feeding and/or discharging of the supplementary current (IE) into and/or from the main line (70).

9. The replacement test module (42) according to Claim 8,
**characterized in that**
at least one of the stubs (90a,b) includes a measuring unit (81) for the supplementary current (IE) flowing there.

10. The replacement test module (42) according to Claim 7 to 9,
**characterized in that**
at least one of the stubs (90a,b) is branched off from at least one of the current dividers (80a,b).

11. The replacement test module (42) according to any one of the preceding claims,
**characterized in that**
a calibration line (92) bridging the brush unit (30) branches off from the main line (70), which ends at a calibration contact (93).

12. The replacement test module (42) according to Claim 11,
**characterized in that**
the calibration line (92) includes a switchable or variable calibration resistance (RK).

13. The replacement test module (42) according to any one of the preceding claims,
**characterized in that**
the replacement test module (42) has an input interface (96) in order to receive a message from the test system (2), at least whether said test system assesses a currently tested wire (6) as continuous (E) or not continuous (F).

14. A method for testing at least one electrical wire (6) of a cable harness (4) with the aid of the replacement test module (42) according to any one of the preceding claims and of the test system (2), wherein the wire (6) has at least one contact end (8a,b),
wherein the method has the following steps:
- the replacement test module (42) is electrically connected in series with the wire (6) between the interfaces (16a,b), wherein the contact end (8a,b) is received in the brush unit (30) and electrically contacted,
- the wire (6) is tested for electrical continuity (E, F) with the aid of the test system (2).

15. The method according to Claim 14 in conjunction with Claims 5 and 11,
**characterized in that**
prior to the start of testing of the wire (6):
- the replacement test module (42) is connected to one of the interfaces (16a,b),
- the calibration contact (93) is connected via a known continuous calibration line (100) to the other interface (16a,b),
- the replacement test module (42) is operated in the diagnostic mode (MD) and subsequently in the follow-up mode (MF) determined there.

16. The method according to Claim 15 in conjunction with Claims 3, 4 and 12,
**characterized in that**
in the diagnostic mode (MD) of the replacement test module (42):
- a) it is determined whether the test system (2) is working with a voltage or current source, and whether the correction end (79) is formed by the contact (62a-d) or the counter-interface (20a,b),
- b) the actual value (WI) of the measurement current (IM) flowing at a calibration resistance (RK) of zero is determined as a good value (WG), and
- at a specifiable calibration resistance (RK), which is at least as large as the usual contact resistance to be expected in the brush arrangement (30), the actual value (WI) of the measurement current (IM) is determined, and
- if the actual value (WI) is below a specifiable minimum value, the reporting mode (MM) is selected as the follow-up mode (MF),
- if the actual value (WI) corresponds to the good value (WG), the passive test mode (MP) is selected as the follow-up mode (MF),
- otherwise, the actual value (WI) is used as the threshold (WS) and the active test mode (MA) is selected as the follow-up mode (MF).

## Revendications

1. Module de contrôle de remplacement (42) pour un système de test (2), le système de test (2) présentant deux interfaces (16a, b) pour le raccordement d'un module de contrôle respectif (18a, b) et le système de test (2) étant adapté pour tester un faisceau de câbles (4) raccordé entre les interfaces (16a, b) au moins pour la continuité électrique (E, F) de ses conducteurs (6), les conducteurs (6) étant à cet effet connectés électriquement par leurs extrémités de contact (8a, b) entre les interfaces (16a, b),
- avec une interface opposée (20a,b) pour le raccordement à l'une des interfaces (16a,b) du système de test (2),
- avec au moins un contact (62a-d) pour la mise en contact électrique d'une extrémité de contact respective (8a, b) du faisceau de câbles (4),
- avec une ligne principale électrique (70) reliant l'interface opposée (20a,b) au contact (62a-d), qui est traversée par un courant de mesure (IM) généré par le système de test (2) pendant le fonctionnement de celui-ci,
- avec une bonne valeur (WG) prédéfinissable par rapport au système de test (2) pour le courant de mesure (IM),
- avec une valeur seuil (WS) prédéfinissable par rapport au module de contrôle de remplacement (42) pour le courant de mesure (IM), qui est inférieure à la bonne valeur (WG),
- le module de contrôle de remplacement (42) contenant une unité de commande (78) qui est adaptée
- pour faire fonctionner le module de contrôle de remplacement (42) au moins dans un mode de contrôle actif (MA) dans lequel :
- une valeur réelle (WI) du courant de mesure (IM) généré par le système de test (2), circulant dans la ligne principale (70) est déterminée, et
- dans le cas où la valeur réelle (WI) est supérieure à la valeur seuil (WS),
- un courant de somme (IS) est prélevé ou délivré sur la ligne principale (70) au niveau du contact (62a-d) ou de l'interface opposée (20a, b) en tant qu'extrémité de correction (79a, b) du module de contrôle de remplacement (42), lequel est composé du courant de mesure (IM) et d'un courant complémentaire (IE) dérivé ou injecté en plus depuis ou dans la ligne principale (70) avec une valeur complémentaire (WE) prédéfinissable, la valeur complémentaire (WE) étant dimensionnée de telle sorte que la valeur du courant de somme (IS) prélevé sur le système de test (2) ou renvoyé au système de test (2) prenne au moins la bonne valeur (WG),
- l'extrémité de correction (79a, b) étant tournée vers l'interface (16a, b) du système de test (2) qui mène à une unité d'évaluation (25) du système de test (2),
- sinon :
- sur la ligne principale (70), le courant de mesure (IM) est délivré inchangé au module de contrôle de remplacement (42) ;
le module de contrôle de remplacement (42) étant **caractérisé en ce que** le contact (62a-d) contient une unité de brosse (30) dans laquelle l'extrémité de contact respective (8a, b) du faisceau de câbles (4) peut être reçue et mise en contact électrique, l'unité de brosse (30) présentant des poils de brosse (40) électriquement conducteurs pour la mise en contact électrique mécaniquement douce de l'extrémité de contact (8a, b).

2. Module de contrôle de remplacement (42) selon la revendication 1,
**caractérisé en ce que**
la valeur complémentaire (WE) correspond à la différence entre la bonne valeur (WG) et la valeur seuil (WS) ou entre la bonne valeur (WG) et la valeur réelle (WI).

3. Module de contrôle de remplacement (42) selon l'une quelconque des revendications précédentes,
**caractérisé en ce que**
l'unité de commande (78) est adaptée
- pour faire fonctionner le module de contrôle de remplacement (42) dans un mode de contrôle passif (MP) dans lequel le courant de mesure (IM) avec sa valeur réelle (WI) est toujours transmis inchangé à travers le module de contrôle de remplacement (42).

4. Module de contrôle de remplacement (42) selon l'une quelconque des revendications précédentes,
**caractérisé en ce que**
l'unité de commande (78) est adaptée
- pour faire fonctionner le module de contrôle de remplacement (42) dans un mode de notification (MM) dans lequel le module de contrôle de remplacement (42) émet une notification (U) indiquant qu'une utilisation du module de contrôle de remplacement (42) avec le système de test (2) n'est pas judicieuse.

5. Module de contrôle de remplacement (42) selon l'une quelconque des revendications précédentes, éventuellement en liaison avec l'une quelconque des revendications 3 à 4,
**caractérisé en ce que**
l'unité de commande (78) est adaptée
- pour faire fonctionner le module de contrôle de remplacement (42) dans un mode de diagnostic (MD) dans lequel le module de contrôle de remplacement (42) détermine des propriétés d'un système de test (2) raccordé et, sur la base de ces propriétés, détermine si le mode de contrôle actif ou - s'il existe - le mode de contrôle passif ou - s'il existe - le mode de notification doit être sélectionné en tant que mode de suivi dans le module de contrôle de remplacement (42) en liaison avec le système de test.

6. Module de contrôle de remplacement (42) selon l'une quelconque des revendications précédentes,
**caractérisé en ce que**
la ligne principale (70) contient un module de mesure (72) pour mesurer le courant.

7. Module de contrôle de remplacement (42) selon la revendication 6,
**caractérisé en ce que**
la ligne principale (70) contient, de part et d'autre du module de mesure (72), un aiguillage de courant respectif (80a, b) qui sont tous deux adaptés pour imposer une direction de courant dans la ligne principale (70).

8. Module de contrôle de remplacement (42) selon l'une quelconque des revendications précédentes,
**caractérisé en ce**
**qu'**au moins une ligne de dérivation (90a, b) menant à une source de courant (77) ou à un puits de courant (71) pour le courant complémentaire (IE) part de la ligne principale (70) et est configurée pour alimenter et/ou évacuer au choix le courant complémentaire (IE) dans et/ou hors de la ligne principale (70).

9. Module de contrôle de remplacement (42) selon la revendication 8,
**caractérisé en ce**
**qu'**au moins une des lignes de dérivation (90a, b) contient une unité de mesure (81) pour le courant complémentaire (IE) qui y circule.

10. Module de contrôle de remplacement (42) selon les revendications 7 à 9.
**caractérisé en ce**
**qu'**au moins une des lignes de dérivation (90a, b) part d'au moins un des aiguillages de courant (80a, b).

11. Module de contrôle de remplacement (42) selon l'une quelconque des revendications précédentes,
**caractérisé en ce**
**qu'**une ligne d'étalonnage (92) part de la ligne principale (70) en contournant l'unité de brosse (30) et se termine au niveau d'un contact d'étalonnage (93).

12. Module de contrôle de remplacement (42) selon la revendication 11,
**caractérisé en ce que**
la ligne d'étalonnage (92) contient une résistance d'étalonnage commutable ou modifiable (RK).

13. Module de contrôle de remplacement (42) selon l'une quelconque des revendications précédentes,
**caractérisé en ce que**
le module de contrôle de remplacement (42) présente une interface d'entrée (96) pour recevoir une notification du système de test (2), au moins pour savoir si celui-ci évalue un conducteur (6) actuellement testé en tant que continu (E) ou non continu (F).

14. Procédé de test d'au moins un conducteur électrique (6) d'un faisceau de câbles (4) à l'aide du module de contrôle de remplacement (42) selon l'une quelconque des revendications précédentes et du système de test (2), le conducteur (6) présentant au moins une extrémité de contact (8a, b),
le procédé présentant les étapes suivantes :
- le module de contrôle de remplacement (42) est connecté électriquement en série avec le conducteur (6) entre les interfaces (16a, b), l'extrémité de contact (8a, b) étant reçue dans l'unité de brosse (30) et mise en contact électrique,
- le conducteur (6) est contrôlé pour la continuité électrique (E, F) à l'aide du système de test (2).

15. Procédé selon la revendication 14 en liaison avec les revendications 5 et 11,
**caractérisé en ce**
**qu'**avant de commencer à tester le conducteur (6) :
- le module de contrôle de remplacement (42) est relié à l'une des interfaces (16a, b),
- le contact d'étalonnage (93) est relié à l'autre interface (16a,b) par l'intermédiaire d'une ligne d'étalonnage (100) connue continue,
- le module de contrôle de remplacement (42) est fait fonctionner dans le mode de diagnostic (MD) et ensuite dans le mode de suivi (MF) qui y est déterminé.

16. Procédé selon la revendication 15 en liaison avec les revendications 3, 4 et 12,
**caractérisé en ce que**
dans le mode diagnostic (MD) du module de contrôle de remplacement (42) :
- a) on détermine si le système de test (2) fonctionne avec une source de tension ou de courant, et si l'extrémité de correction (79) est formée par le contact (62a-d) ou l'interface opposée (20a,b),
- b) la valeur réelle (WI) du courant de mesure (IM) circulant pour une résistance d'étalonnage (RK) de zéro est déterminée en tant que bonne valeur (WG), et
- la valeur réelle (WI) du courant de mesure (IM) est déterminée pour une résistance d'étalonnage (RK) prédéfinissable, qui est au moins aussi grande que la résistance de contact habituelle attendue dans l'agencement de brosse (30), et
- si la valeur réelle (WI) est inférieure à une valeur minimale prédéfinissable, le mode de notification (MM) est sélectionné en tant que mode de suivi (MF),
- si la valeur réelle (WI) correspond à la bonne valeur (WG), le mode de contrôle passif (MP) est sélectionné en tant que mode de suivi (MF),
- sinon, la valeur réelle (WI) est utilisée en tant que valeur seuil (WS) et le mode de contrôle actif (MA) est sélectionné en tant que mode de suivi (MF).
